(19) **Europäisches Patentamt / European Patent Office / Office européen des brevets**

(11) **EP 0 938 140 B1**

(12) ## EUROPEAN PATENT SPECIFICATION

(45) Date of publication and mention
of the grant of the patent:
**31.01.2007 Bulletin 2007/05**

(51) Int Cl.:
*H01L 29/737* (2006.01)

(21) Application number: **99103330.9**

(22) Date of filing: **19.02.1999**

(54) **Semiconductor device with bipolar transistor**

Halbleiterbauelement mit Bipolartransistor

Dispositif semiconducteur avec transistor bipolaire

(84) Designated Contracting States:
**DE FR GB**

(30) Priority: **20.02.1998 JP 3875898**
**03.06.1998 JP 15468998**
**03.06.1998 JP 15470098**

(43) Date of publication of application:
**25.08.1999 Bulletin 1999/34**

(60) Divisional application:
**01123874.8 / 1 178 537**

(73) Proprietor: **MATSUSHITA ELECTRIC INDUSTRIAL CO., LTD.**
**Kadoma-shi, Osaka 571-8501 (JP)**

(72) Inventors:
• **Takagi, Takeshi**
**Kyoto-shi,**
**Kyoto 616-8182 (JP)**
• **Harafuji, Kenji**
**Hirakata-shi,**
**Osaka 573-1148 (JP)**

(74) Representative: **Grünecker, Kinkeldey,**
**Stockmair & Schwanhäusser**
**Anwaltssozietät**
**Maximilianstrasse 58**
**80538 München (DE)**

(56) References cited:
**GB-A- 2 260 858      GB-A- 2 288 691**
**US-A- 5 426 316**

• **PATENT ABSTRACTS OF JAPAN vol. 098, no. 002, 30 January 1998 (1998-01-30) & JP 09 283533 A (MATSUSHITA ELECTRIC IND CO LTD), 31 October 1997 (1997-10-31)**
• **KARLSTEEN M ET AL: "Improved switch time of IL at low power consumption by using a SiGe heterojunction bipolar transistor" SOLID STATE ELECTRONICS, vol. 38, no. 7, 1 July 1995 (1995-07-01), page 1401-1407 XP004011832**
• **GOOSSEN K W ET AL: "PLANARIZATION OF EMITTER-BASE STRUCTURE OF HETEROJUNCTION BIPOLAR TRANSISTORS BY DOPING SELECTIVE BASE CONTACT AND NONALLOYED EMITTER CONTACT" IEEE TRANSACTIONS ON ELECTRON DEVICES, vol. 38, no. 11, 1 November 1991 (1991-11-01), pages 2423-2426, XP000225980 ISSN: 0018-9383**
• **HARAME D L ET AL: "OPTIMIZATION OF SIGE HBT TECHNOLOGY FOR HIGH SPEED ANALOG AND MIXED-SIGNAL APPLICATIONS" PROCEEDINGS OF THE INTERNATIONAL ELECTRON DEVICES MEETING, WASHINGTON, DEC. 5 - 8, 1993,5 December 1993 (1993-12-05), pages 71-74, XP000481571 INSTITUTE OF ELECTRICAL AND ELECTRONICS ENGINEERS ISBN: 0-7803-1451-4**

EP 0 938 140 B1

Description

## BACKGROUND OF THE INVENTION

The present invention relates to a semiconductor device having a heterojunction portion such as a bipolar transistor, a diode, or an I$^2$L.

Because of its excellent RF characteristics, a bipolar transistor has conventionally been used as an active device operable in the microwave/milliwave bands. In particular, most vigorous research and development has been directed to a heterojunction bipolar transistor (HBT) using a III-V compound semiconductor such as GaAs. In recent years, attention has been focused on a HBT using a SiGe material, which is a IV-IV compound material that can be fabricated on a low-cost silicon substrate.

The following are the two representative types of structures for implementing higher-speed SiGe HBTs. One of the two types is a HBT reported in Document 1 (L. Harame et al., "Optimization of SiGe HBT Technology for High Speed Analog and Mixed-Signal Applications," IEDM Tech. Dig. 1993, p.71), which comprises a Si collector layer, a SiGe base layer, and a Si emitter layer. In the SiGe base layer, a Ge composition ratio is increased gradually from a region in contact with the Si emitter layer toward a region in contact with the Si collector layer to provide a graded composition base layer. The other of the two types is a HBT reported in Document 2 (A. Schuppen et al., "Enhanced SiGe Heterojunction Bipolar Transistors with 160 GHz-fmax," IEDM Tech. Dig. 1995, p.743.), which comprises a Si collector layer, a SiGe base layer, and a Si emitter layer. The SiGe base layer has an extremely reduced thickness, an increased Ge composition ratio, and an increased doping concentration to provide a uniform composition base layer.

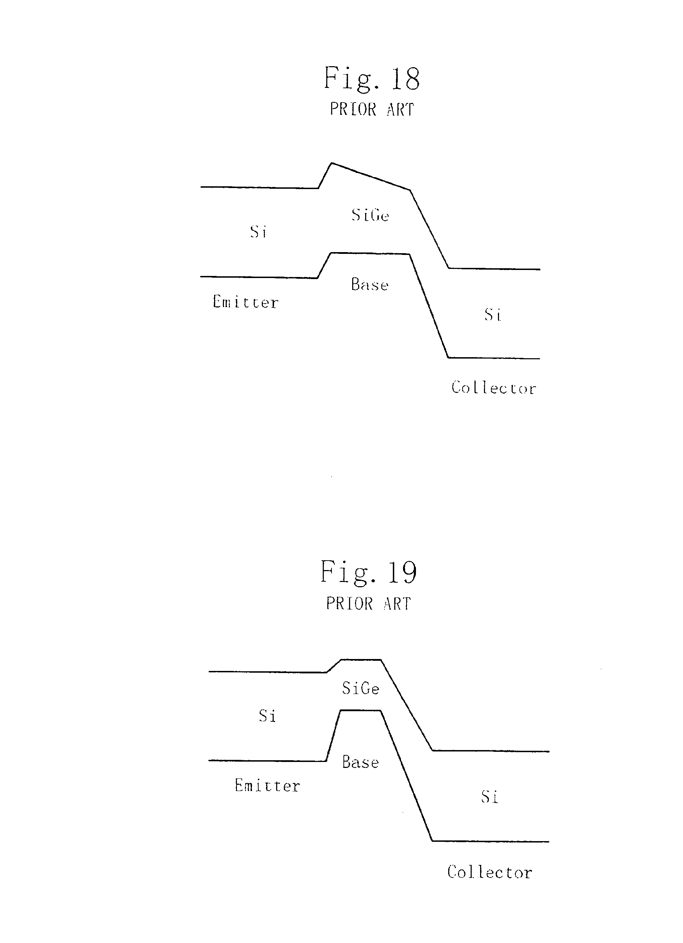

Figure **18** is a band diagram of the former heterojunction bipolar transistor having the graded composition base layer. As can be seen from the band state shown in the drawing, an electric field induced by the graded composition causes carriers injected into the SiGe base layer to drift in the SiGe base layer toward the collector layer. Since the traveling of the carriers caused by the drift electric field is at a higher speed than the traveling thereof caused by diffusion, a base transit time is reduced and excellent RF characteristics are obtained.

Figure **19** is a band diagram of the latter heterojunction bipolar transistor having the uniform composition base structure. As can be seen from the band state shown in the drawing, the base layer is extremely thinned to reduce the base transit time and provide excellent RF characteristics. In this case, the thinning of the base layer incurs the risk of increasing the base resistance, so that the base layer is doped with a high-concentration impurity to lower the base resistance. In addition, SiGe having a high Ge composition ratio is used in the base layer to prevent reverse injection of carriers from the base layer doped with the high-concentration impurity into the emitter, so that a heterojunction barrier formed between the SiGe base layer and the Si emitter layer is increased. In this case also, excellent RF characteristics are obtained. In particular, the doping concentration in the base layer is increased to reduce the base resistance and thereby increase a maximum oscillation frequency.

In a conventional Si LSI using a bipolar transistor, on the other hand, it has frequently been performed to compose a diode by using a PN junction portion between the base and collector of the NPN bipolar transistor and use the diode as an element of a logic circuit. This is because the NPN bipolar transistor has a structure suitable for the formation of a large number of built-in diodes since the PN junction portion between the base and collector has a high breakdown voltage (with respect to a reverse bias) and the N-type collector layer is used as a common region in the substrate.

However, such a PN junction diode has the drawback that it is unsuitable for use in a device operating at a high speed due to minority carriers accumulated in each of the P-type and N-type regions thereof. Specifically, electrons as minority carriers are accumulated in the P-type base layer of the NPN bipolar transistor layer, while holes as minority carriers are accumulated in the N-type collector layer thereof. In a typical high-speed bipolar transistor, the P-type base layer is formed extremely thin to reduce the base transit time so that the accumulation of the electrons in the P-type base layer presents substantially no problem even in the PN junction diode composed by using a part of the bipolar transistor. However, the N-type collector layer is formed to have a sufficient thickness in the range of 0.5 to 1 $\mu$m in order to retain a high breakdown voltage, so that numerous holes are accumulated therein, which eventually limits the speed of the PN junction diode.

As a method of increasing the operating speed by suppressing the accumulation of minority carriers in such a collector region, there has been known one reported in Document 3 (M. Ugajin et al., "The base-collector heterojunction effect in SiGe-base bipolar transistors," Solid-State Electron., vol.34, pp.593, 1991), in which a SiGe/Si heterojunction is provided in the base/collector junction to impart a wider band gap to the collector layer. By thus imparting the wider band gap to the collector layer, a heterojunction barrier is formed in the base/collector junction portion to suppress injection of holes from the base layer to the collector layer, thereby reducing the amount of holes accumulated in the collector and increasing the operating speed of the diode.

There has also been known a method disclosed in Document 4 (M. Karlsteen et al., "Improved switch time of I2L at low power consumption by using a SiGe heterojunction bipolar transistor," Solid-State Electron., vol.38, pp.1401, 1995), in which a heterojunction is provided in a base/collector junction portion in an I[2]L (Integrated Injection Logic) circuit into which a plurality of bipolar transistors have been integrated, thereby suppressing the accumulation of minority carriers and increasing the operating speed.

However, the aforesaid bipolar transistor and the diode using the bipolar transistor have the following disadvantages.

In the conventional HBT using the graded composition base shown in Figure **18**, it is required to greatly vary the Ge composition ratio in order to increase the intensity of the drift electric field induced by the graded composition. In short, it is required to minimize the Ge composition ratio in a region of the base layer in contact with the emitter layer and maximize the Ge composition ratio in a region of the base layer in contact with the collector layer. To satisfy the requirement, the region of the base layer in contact with the emitter layer normally has a pure Si composition without containing Ge, so that the base/emitter PN junction forms a silicon/silicon homojunction. In increasing the maximum oscillation frequency fmax of the HBT, it is effective to reduce the base resistance as represented by the following equation (1). If a base doping concentration is increased to reduce the base resistance, however, an increased number of holes are naturally injected from the base layer into the emitter layer.

In the case where the emitter/base junction forms a homojunction or where the emitter/base junction forms a heterojunction but has a nearly pure Si composition at the end of the base, the quantity of carriers reversely injected into the emitter is increased because the base layer has no heterojunction barrier at all or, if any, an extremely low heterojunction barrier, so that the current amplification factor β is not increased.

$$f_{max} = \sqrt{\frac{f_T}{8\pi \cdot R_B \cdot C_{BC}}} \qquad \cdots\cdots \quad (1)$$

$f_T$: current gain cutoff frequency
$R_B$: base resistance
$C_{SC}$: base/collector junction capacitance

The fact that the current amplification factor β is not increased can also be derived from the relationship represented by the following equation (2), which is established among the current amplification factor β, the band discontinuity value ΔEv of a valence band at the emitter/base junction portion, and a carrier concentration $N_B$ in the base layer.

$$\beta = \frac{J_n}{J_p} = \left(\frac{N_E}{N_B}\right) \cdot \left(\frac{V_n}{V_p}\right) \cdot \exp\left(\frac{\Delta E_V}{kT}\right) \qquad \cdots\cdots \quad (2)$$

$N_E$: carrier concentration in emitter layer
$N_B$: carrier concentration in base layer
$V_n$: speed of electron diffusion in base layer
$V_p$: speed of hole diffusion in emitter layer
k: Boltzmann's constant
T: absolute temperature.

In the case of using such a graded composition base, it becomes therefore possible to reduce the base transit time of carriers and improve the current gain cutoff frequency $f_T$. However, the increase of the maximum oscillation frequency fmax cannot eventually be expected since the concentration of carriers in the base layer cannot be increased.

On the other hand, the conventional structure using the uniform composition base shown in Figure **19** can suppress reverse injection of carriers from the base layer because a high heterojunction barrier is formed between the SiGe base layer having a high Ge composition ratio and a Si emitter layer. If the concentration of carriers in the SiGe base layer (base doping concentration) is to be further increased in order to increase the maximum oscillation frequency fmax, as described above, the quantity of carriers reversely injected is increased. To prevent this, it is required to further enhance the height of the heterojunction barrier by further increasing the Ge composition ratio in the SiGe base layer, which increases the difference in lattice constant between the emitter layer and the base layer. As a result, a critical film thickness at which a dislocation occurs in the base layer presents a problem.

It is generally known that a lattice strain develops in a SiGe layer formed by crystal growth on a Si substrate due to the difference in lattice constant between Si and Ge, which is released if the Ge composition ratio is high and the film thickness is large and thereby causes a dislocation in the film as well as a fatal damage to the element. The film thickness at which a dislocation occurs is generally termed the critical film thickness. The critical film thickness is smaller as the Ge composition ratio in the SiGe layer is higher. The critical film thickness is on the order of 50 nm when the Ge composition ratio is 30%, which corresponds to the film thickness of the base layer.

Even when the film thickness of the SiGe layer is equal to or smaller than the critical film thickness, the SiGe layer is not in a completely stable state but in a quasi-stable state if the Ge composition ratio is high. If a high-temperature process is performed in a subsequent step, such a defect as dislocation is easily caused. Hence, it is inappropriate in terms of device reliability and a thermal budget during a device fabrication process to use a SiGe layer having a high Ge composition ratio.

Therefore, there is a limit to the improvement of the RF characteristics of a bipolar transistor which is accomplished by providing a heterojunction in the emitter/base junction and enhancing the function of suppressing reverse injection of carriers from the base into the emitter through the formation of a heterojunction.

On the other hand, there is a limit to the increase of the operating speed of a conventional device such as a bipolar transistor or diode reported in Document 3 or 4 which is accomplished by providing a heterojunction in the base/collector junction, suppressing injection of minority carriers from the base layer into the collector layer, and thereby reducing the accumulated carriers.

The reason for this is that, as reported in Document 3, a considerably high heterojunction barrier is required to reduce the quantity of holes accumulated in the N-type Si collector layer of a Si/SiGe HBT to the order of the quantity of electrons accumulated in the P-type SiGe base layer thereof. Specifically, a heterojunction barrier of a height of the order of 0.2 eV is required. To form such a heterojunction barrier at the base/collector junction composed of a SiGe/Si multiple layer, the Ge composition ratio in the base layer should be at least 25% or higher.

However, since the thickness of the base layer is preferably reduced to a value equal to or smaller than the critical film thickness and device reliability and the thermal budget during the device fabrication process should be ensured, as described above, a Ge composition ratio in the SiGe layer which is 25% or higher is excessively high in terms of reliability and manufacturability.

Hence, it is problematic to increase the Ge composition ratio in the SiGe layer in order to increase the height of a heterojunction barrier formed at the base/collector heterojunction.

A triple heterojunction bipolar transistor is known from US 5426316. A high speed semiconductor device and production method therefor is known from GB 2288691 corresponding to the preamble of claim 1. A heterojunction bipolar transistor is known from JP 09283533.

## SUMMARY OF THE INVENTION

A first object of the present invention according to claim 1 is to provide a bipolar transistor wherein a current amplification factor is increased with the provision of a region having the function of suppressing reverse injection of carriers from the base layer into the emitter layer irrespective of a barrier formed at the emitter/base junction. In the bipolar transistor, the current amplification factor can be improved even when a base doping concentration is increased to increase the maximum oscillation frequency fmax by relaxing restrictions on the increase of the current amplification factor.

A second object of the present invention is to provide an element functioning as a bipolar transistor, a diode, an $I^2L$ element, or the like which operates at a high speed by suppressing the injection of minority carriers from the base layer into the collector layer and thereby reducing the quantity of minority carriers accumulated in the collector layer. This can be achieved by providing means for effectively increasing a heterojunction barrier formed at the base/collector junction without increasing the Ge composition ratio in the SiGe base layer to such a value as to excessively reduce the critical film thickness, i.e., by implementing a structure which ensures sufficiently high reliability.

To attain the first object, a first bipolar transistor according to the present invention according to claim 1 has a multi-quantum barrier (MQB) composed of a superlattice structure consisting of two types of extremely thin films having different compositions and alternately stacked, which is provided in a region of the emitter adjacent the emitter/base junction. The MQB reflects a wave of carriers reversely injected from the base, which fact is used to effectively increase the height of a hetero-junction barrier (barrier height) and thereby suppress the reverse injection of the carriers from the base layer. Specifically, the first bipolar transistor has the following structure.

The first bipolar transistor according to the present invention according to claim 1 comprises an emitter layer, a base layer, and a collector layer, the bipolar transistor having a multi-quantum barrier portion being provided in the emitter layer and composed of a plurality of barrier layers and well layers alternately stacked to perform the function of reflecting an incident wave of minority carriers in the emitter layer injected from the base layer and provide such a phase that the incident wave of carriers and a reflected wave of carriers intensify each other.

With the arrangement, not only a barrier induced by the discontinued valence band at the emitter/base junction but also the reflecting function of the multi-quantum barrier portion prevents reverse injection of carriers from the base layer. Since the reverse injection of carriers is suppressed, it becomes possible to increase the current amplification factor and improve RF characteristics including maximum oscillation frequency fmax even if the carrier concentration in the base layer is increased.

By composing the barrier layers and well layers of the multi-quantum barrier portion of respective semiconductor materials having different band gaps, there can easily be implemented a multi-quantum barrier layer having the function of suppressing reverse injection of carriers.

By setting the band discontinuity value of a band in the emitter layer containing the multi-quantum barrier portion, through which majority carriers flow, at a substantially negligible value, there is provided a band structure presenting no obstacle to the movement of majority carriers in the emitter layer, which enhances the effect of improving a current amplification factor.

With the base layer being strained, a particularly high effect is achieved when the difference in lattice constant between the emitter layer and the base layer is large.

By composing the emitter layer and the base layer of respective semiconductor materials having different band gaps and providing, in a band gap between a valence band and a conduction band in the base layer, a portion gradually decreasing from a region of the base layer in contact with the emitter layer toward a region of the base layer in contact with the collector layer, the traveling speed of carriers in the base layer is determined by a drift velocity, not by a diffusion speed, so that the base transit time is reduced and a current gain cut-off frequency fT is increased. In addition, the multi-quantum barrier portion suppresses reverse junction of carriers from the base layer into the emitter layer irrespective of the band discontinuity value reduced by the provision of the graded composition base. Moreover, there can also be achieved a reduced base resistance attributable to higher-concentration base doping or an increased thickness of the base layer, which increases a maximum oscillation frequency fmax.

By composing the multi-quantum barrier portion of a superlattice structure of a $Si_{1-x-y}Ge_xC_y$/Si multiple layer, the critical film thickness of the $Si_{1-x-y}Ge_xC_y$ layer at the multi-quantum barrier portion is particularly increased, so that it becomes possible to further increase the effective barrier height of the multi-quantum barrier portion without incurring a dislocation.

With the multi-quantum barrier portion being disposed in a region of the emitter layer exterior to a depletion region formed between the emitter layer and the base layer at a working voltage when the transistor is operating, the function of suppressing reverse injection of carriers from the base into the emitter can maximally be performed in any operating condition.

By disposing the barrier layer at the end of the multi-quantum barrier portion closer to the base layer in such a position as to prevent the tunneling of the carriers from the depletion region formed between the emitter layer and the base layer to the well layer adjacent to the barrier layer at the end of the multi-quantum barrier portion closer to the base layer, such improved RF characteristics as described above can be expected without degrading the function of suppressing reverse injection of carriers performed by the multi-quantum barrier portion.

To attain the first object, a second bipolar transistor has a high-concentration doped layer for effectively enhancing the function of suppressing reverse injection of carriers from the base layer into the emitter layer, which is provided in the emitter layer of the bipolar transistor. Specifically, the second bipolar transistor has the following structure.

The second bipolar transistor comprises an emitter layer containing an impurity of a first conductivity type, a base layer containing an impurity of a second conductivity type, and a collector layer containing the impurity of the first conductivity type, the bipolar transistor having a high-concentration doped layer being provided in the emitter layer and doped with the impurity of the first conductivity type at a higher concentration than in the emitter layer.

This produces not only a barrier induced by a discontinued valence band at the emitter/base junction but also a potential barrier induced by a high-concentration doped layer in the valence band of the emitter layer, so that the carriers in the base layer are inhibited from being reversely injected into the emitter layer. By suppressing reverse injection of carriers, therefore, it becomes possible to improve the current amplification factor as well as the RF characteristics including maximum oscillation frequency fmax even if the carrier concentration in the base layer is increased.

Preferably, the high-concentration doped layer is a δ-doped layer having a thickness of 10 nm or less.

Preferably, the concentration of carriers of the first conductivity type in the high-concentration doped layer is $1 \times 10^{19}$ cm$^{-3}$ or more.

Preferably, the concentration of carriers of the first conductivity type in the high-concentration doped layer is more than ten times higher than the concentration of the carriers of the first conductivity type in the emitter layer.

With the high-concentration doped layer being adjacent to a depletion region formed at an emitter/base junction portion, there can maximally be performed the function of suppressing reverse injection of carriers from the base to the emitter.

Preferably, the concentration of carriers of the second conductivity type in the base layer is higher than the concentration of carriers of the first conductivity type in the emitter layer.

By composing the emitter layer and the base layer of two types of semiconductor materials having different band gaps, imparting the wider band gap to the semiconductor material composing the emitter layer, and providing a heterojunction portion between the emitter layer and the base layer, the function of suppressing reverse injection of carriers from the base layer is further enhanced by using a high barrier at the heterojunction portion. In that case, the strained base layer achieves a particularly high effect when the difference in lattice constant between the emitter layer and the base layer is large.

To attain the second object, a semiconductor device according to the present invention according to claim 10 has a multi-quantum barrier (MQB) having a superlattice structure consisting of two types of extremely thin films having different compositions and alternately stacked, which is provided in a region of the collector layer in contact with the collector/base junction. The height of the heterojunction barrier (barrier height) has been effectively increased by using the effect of reflecting a wave of carriers injected from the base (minority carriers in the collector layer). Specifically, the semiconductor device has the following structure.

The semiconductor device according to the present invention according to claim 10 comprises a bipolar transistor comprises an emitter layer, a base layer, and a collector layer, the bipolar transistor having a multi-quantum barrier portion being provided in the collector layer and composed of a plurality of barrier layers and well layers alternately stacked to perform the function of reflecting an incident wave of minority carriers in the collector layer injected from the base layer (minority carriers in the collector layer) and provide such a phase that the incident wave and a reflected wave intensify each other.

In the arrangement, the carriers in the base layer are prevented from being injected into the collector layer not only by a barrier induced by a discontinued valance band at the collector/base junction but also by the reflecting function performed by the multi-quantum barrier portion. By suppressing the injection of minority carriers, therefore, the accumulation of the minority carriers in the collector layer is prevented and the operating speed of a bipolar transistor or the like is increased even if the carrier concentration in the base layer is increased.

The semiconductor device can also comprise an additional structure similar to the structure of the first bipolar.

By further providing the semiconductor device with an element having, as components, two regions having the same structure as a base/collector junction of the bipolar transistor, there can be obtained an element operating at a high speed by using the function of suppressing injection of minority carriers performed by the multi-quantum barrier portion. The element is, e.g., a diode.

By further providing the semiconductor device with another bipolar transistor comprising a collector layer disposed in a region used commonly by the base layer of the bipolar transistor, a base layer disposed in a region used commonly by the collector layer of the bipolar transistor, and an emitter layer, the semiconductor device is caused to function as an $I^2L$ element occupying a smaller area and operating at a high speed.

In that case, it is also possible to provide at least one other collector layer connected to the base layer of the bipolar transistor and another multi-quantum barrier portion being disposed in the one other collector layer and composed of a plurality of barrier layers and well layers alternately stacked to perform the function of reflecting an incident wave of carriers injected from the base layer (minority carriers in the collector layer) and provide such a phase that the incident wave and a reflected wave intensify each other.

## BRIEF DESCRIPTION OF THE DRAWINGS

Figure **1** is a cross-sectional view of an NPN heterojunction bipolar transistor according to a first embodiment, in which a MQB layer as a Si/SiGe multi-quantum barrier portion is provided in the emitter layer;

Figure **2** is a band diagram of the NPN heterojunction bipolar transistor according to the first embodiment, in which the MQB layer as the Si/SiGe multi-quantum barrier portion is provided in the emitter layer;

Figure **3** is a band diagram showing a model for calculating a barrier height $\Delta Ue$ enhanced by the MQB layer in the transistor;

Figure **4** shows the result of calculating the barrier height $\Delta Ue$ enhanced by the MQB layer;

Figure **5** shows the result of calculating the degree to which a base transit time has been reduced in the HBT of the present invention having the barrier height enhanced by the MQB layer and a graded composition base layer, compared with the base transit time in the conventional HBT having the uniform composition base layer;

Figure **6** shows the result of calculating the degree to which a maximum oscillation frequency fmax has been increased in the HBT of the first embodiment having the barrier height enhanced by the MQB layer and the graded composition base layer with an increased film thickness, compared with the conventional HBT having the graded composition base layer;

Figure **7 (a)** is a band diagram of the bipolar transistor of the first embodiment showing an improved temperature characteristic and Figure **7(b)** is a graph plotted as a function of temperature against a current amplification factor;

Figure **8** is a cross-sectional view of an NPN heterojunction bipolar transistor, in which a $\delta$-doped Si layer is provided in the emitter layer;

Figure **9** is a cross-sectional view of the NPN heterojunction bipolar transistor, in which the $\delta$-doped Si layer is provided in the emitter layer;

Figure **10** is a band diagram of an NPN heterojunction bipolar transistor in which the $\delta$-doped Si layer is not provided in the emitter layer;

Figure **11** shows the relationship between a carrier concentration and an increase in effective barrier height in the $\delta$-doped Si layer;

Figure **12** shows the relationship between a current amplification factor $\beta$ and a collector current in the NPN heterojunction bipolar transistor in each of the cases where the $\delta$-doped Si layer is provided and not provided in the emitter layer;

Figure **13** is a cross-sectional view of an NPN heterojunction bipolar transistor according to a second embodiment, in which a MQB layer as a Si/SiGe multi-quantum barrier portion is provided in the collector layer;

Figure **14** is a band diagram of the NPN hetero bipolar transistor according to the second embodiment, in which the MQB layer is provided in the collector layer;

Figure **15** is a cross-sectional view showing a structure of an I$^2$L element according to a third embodiment, in which a MQB layer is provided in each of two collector layers;

Figure **16** is an electric circuit diagram showing a circuit equivalent to the I$^2$L element according to the third embodiment;

Figure **17** is a cross-sectional view of a semiconductor device according to a fourth embodiment having a bipolar transistor in which a MQB layer is provided in the collector layer and a diode composed by using only the base and collector of the bipolar transistor;

Figure **18** is a cross-sectional view of the conventional SiGe NPN heterojunction bipolar transistor using the graded composition base layer; and

Figure **19** is a band diagram of the conventional SiGe NPN heterojunction bipolar transistor using the uniform composition base layer.

## DETAILED DESCRIPTION OF THE INVENTION

EMBODIMENT 1

The present embodiment relates to a heterojunction bipolar transistor having a multi-quantum barrier composed of a superlattice structure consisting of two types of extremely thin films having different compositions and alternately stacked, which is provided in a region of the emitter adjacent the emitter/base junction.

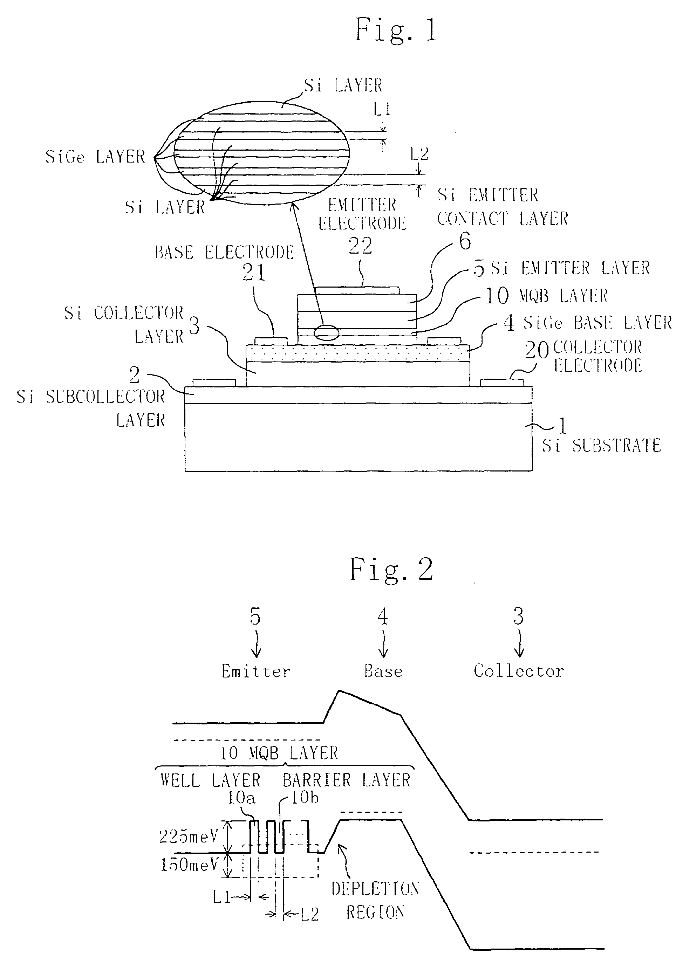

Figure **1** is a cross-sectional view showing a structure of an NPN heterojunction bipolar transistor having a multi-quantum barrier composed of a Si/SiGe superlattice provided in the emitter layer according to the present embodiment. As shown in the drawing, there are provided: a high-concentration n-type Si subcollector layer **2** doped with arsenic; an n-type Si collector layer **3** doped with arsenic; a high-concentration p-type SiGe base layer **4** doped with boron; an n-type Si emitter layer **5** doped with arsenic; and a high-concentration n-type Si emitter contact layer **6** doped with arsenic that have been stacked sequentially on a Si substrate **1**. A collector electrode **20**, a base electrode **21**, and an emitter electrode **22** are disposed on the Si subcollector layer **2**, the SiGe base layer **4**, and the Si emitter contact layer **6**, respectively.

The thickness of the high-concentration n-type Si subcollector layer **2** is approximately 500 nm and the concentration of arsenic (n-type impurity) in the Si subcollector 2 is approximately $2 \times 10^{19}$ cm$^{-3}$. The thickness of the n-type Si collector layer **3** is approximately 650 nm and the concentration of arsenic in the Si collector layer **3** is approximately $1 \times 10^{17}$ cm$^{-3}$. The thickness of the high-concentration p-type SiGe base layer **4** is approximately 50 nm and the concentration of boron (p-type impurity) in the SiGe base layer **4** is approximately $1 \times 10^{19}$ cm$^{-3}$. The thickness of the n-type Si emitter layer **5** is approximately 100 nm and the concentration of arsenic in the Si emitter layer **5** is approximately $2 \times 10^{18}$ cm$^{-3}$. The thickness of the high-concentration n-type Si emitter contact layer **6** is approximately 50 nm and the concentration of arsenic in the Si emitter contact layer **6** is approximately $2 \times 10^{19}$ cm$^{-3}$. These layers have been stacked sequentially by MBE.

A MQB layer **10** as a multi-quantum barrier portion having a superlattice structure composed of extremely thin Si and SiGe layers that have been alternately stacked is provided in a region of the Si emitter layer **5** adjacent the emitter/base junction portion. The MQB layer **10** has such a structure that the compositions and film thicknesses thereof have been adjusted to reflect a wave of holes reversely injected from the SiGe base layer **4** into the Si emitter layer **5** and provide a phase in which the incident wave of holes and a reflected wave of holes intensify each other. Specifically, the MQB layer **10** has a multilayer structure consisting of well layers **10a** each composed of a SiGe layer with a thickness of L1 and barrier layers **10b** each composed of a Si layer with a thickness of L2. The respective thicknesses and compositions of the well layers **10a** and barrier layers **10b** are determined to satisfy the relationship represented by the following equation (3).

$$\left. \begin{array}{c} \dfrac{\sqrt{2m_1 * E}}{h} \cdot L_1 = \dfrac{2m-1}{4} \\[2em] \dfrac{\sqrt{2m_2 * (E - \Delta Ev)}}{h} \cdot L_2 = \dfrac{2n-1}{4} \end{array} \right\} \quad \cdots\cdots \quad (3)$$

m1*: effective mass of holes in SiGe layer (well layer)
m2*: effective mass of holes in Si layer (barrier layer)
L1: thickness of SiGe layer (well layer)
L2: thickness of Si layer (barrier layer)
E: energy of incident holes
ΔEv: valence band discontinuity value at Si/SiGe heterojunction
h: Planck's constant
m, n: integers

Specifically, the MQB layer **10** according to the present embodiment is composed of a superlattice layer consisting of five pairs of the barrier layers **10b** each formed of Si having a thickness of 1.4 nm and the well layers **10a** each formed of $Si_{0.7}Ge_{0.3}$ having a thickness of 1.4 nm. In this case, the MQB increases an effective barrier height by approximately 150 meV.

On the other hand, the SiGe base layer **4** has a graded composition base structure in which a Ge composition ratio increases substantially continually from 0% to 20% from a region in contact with the Si emitter layer **5** toward a region in contact with the Si collector layer **3**.

Figure **2** is a band diagram of the NPN heterojunction bipolar transistor having the multi-quantum barrier layer composed of the Si/SiGe superlattice and provided in the Si emitter layer **5** according to the present embodiment. As shown in the drawing, the multi-quantum barrier (MQB) layer **10** consisting of the five pairs of Si barrier layers **10b** and $Si_{0.7}Ge_{0.3}$ well layers **10a** is provided in the region of the Si emitter layer **5** adjacent the emitter/base junction. A potential barrier indicated by the broken lines in Figure **2** is formed due to the existence of the MQB layer **10**. The potential barrier operates to reflect holes likely to flow from the SiGe base layer **4** into the Si emitter layer **5**, which has enhanced the effective barrier height sensed by the holes likely to flow from the SiGe base layer **4** by approximately 150 meV. The enhanced effective barrier height suppresses reverse injection of the holes into the Si emitter layer **5** even when a hole concentration in the SiGe base layer **4** is increased and thereby provides a sufficient current gain. As a result, there can be implemented a HBT having an extremely high maximum oscillation frequency fmax.

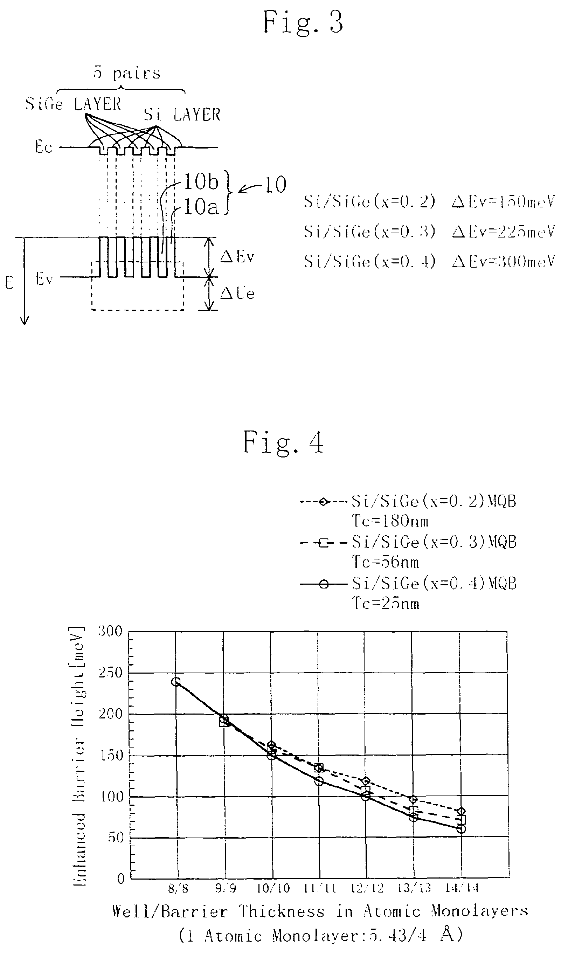

Figure **3** shows a model for calculating a barrier height Δ Ue enhanced by the MQB layer **10** according to the present invention. The enhanced barrier height/ΔUe in each of the five pairs of Si/SiGe superlattice structures composing the MQB layer **10** was calculated for the three structures of $Si/Si_{0.8}Ge_{0.2}$, $Si/Si_{0.7}Ge_{0.3}$, and $Si/Si_{0.6}Ge_{0.4}$. At this time, the respective band discontinuity values ΔEv of the valence bands at the individual heterojunctions between the well layers **10a** and the barrier layers **10b** are 150 meV, 225 meV, and 300 meV. As shown in Figure **3**, the difference in energy level between the lower end of the potential barrier (see the broken lines in Figure **3**) formed due to the existence of the MQB layer **10** and the valence band corresponds to the barrier height ΔUe enhanced by the MQB layer **10**.

Although the energy level Ec of a conduction band in the whole emitter layer **5** including the MQB layer **10** is shown substantially flat in Figure **3**, to be more precise, the energy level of the conduction band actually lowers slightly in the portions of the SiGe layers of the MQB layer **10** compared with the energy level of the conduction band in the Si layer. However, the band discontinuity value in the whole Si emitter layer **5** including the MQB layer **10** may well be considered as substantially zero, since the lowering of the energy level is negligible.

Figure **4** shows the result of calculating the barrier heights ΔUe enhanced by the MQB layer **10** by varying the number of the atomic monolayers of well layers **10a** and barrier layers **10b**. The calculations were performed by varying x to 0.2, 0.3, and 0.4 in $Si_{1-x}Ge_x$ representing SiGe composing the well layers **10a**, i.e., for the three structures of $Si/Si_{0.8}Ge_{0.2}$, $Si/Si_{0.7}Ge_{0.3}$, and $Si/Si_{0.6}Ge_{0.4}$. In the drawing, the horizontal axis represents a well/barrier thickness expressed in the number of atomic monolayers (one atomic monolayer corresponds to (5.43/4)Å). As shown in the drawing, the enhanced barrier height ΔUe in the MQB layer **10** tends to decrease with an increase in the number of monolayers in any of the cases where x is varied to 0.2, 0.3, and 0.4. If the number of monolayers is excessively reduced, there may occur the case where the probability of holes passing through the MQB layer **10** becomes nonzero, though it is not shown in the drawing.

The maximum value of the enhanced barrier height Δ Ue increases with an increase in Ge composition ratio to reach approximately 240 meV when each of Si and $Si_{0.6}Ge_{0.4}$ of $Si/Si_{0.6}Ge_{0.4}$ is composed of 8 atomic monolayers. When the effective barrier height in the MQB layer **10** is increased by about 240 meV, the function of suppressing reverse injection of holes from the SiGe base layer **4** into the Si emitter layer **5** is performed particularly remarkably.

Even if there are slight fluctuations in the film thicknesses and compositions of the MQB layer **10**, the function of suppressing reverse injection of holes mentioned above will easily be performed provided that the effective barrier height ΔUe in the MQB layer **10** is on the order of 100 meV or more.

In order to enhance the barrier height ΔUe when SiGe is used in the well layers **10a** of the MQB layer **10**, it is necessary to further increase the Ge composition ratio in the well layers **10a**. However, the increased Ge composition ratio may cause a dislocation depending on the critical film thickness of SiGe. The respective critical film thicknesses for $Si_{0.8}Ge_{0.2}$, $Si_{0.7}Ge_{0.3}$, and $Si_{0.6}Ge_{0.4}$ when the underlie is Si are approximately 180 nm, 56 nm, and 25 nm.

In increasing the critical film thickness, it is effective to use $Si_{1-x-y}Ge_xC_y$ and Si to compose the well layers **10a** and barrier layers **10b** of the MQB layer **10**, respectively. By adjusting the Ge composition to 40% or more and adding a slight amount of C (on the order of several percentage) thereto, a strained lattice can be alleviated without greatly varying the magnitude of the band discontinuity value ΔEv at the emitter/base junction, which increases the critical film thickness of the well layer **10a**. By thus composing the MQB layer **10a** of $Si_{1-x-y}Ge_xC_y$, a larger band discontinuity value ΔEv can be obtained without exceeding the critical film thickness, which effectively suppresses reverse injection of holes from the SiGe base layer **4** into the emitter layer **5**.

Next, a description will be given to the effect of improving the RF characteristics of the HBT in which the effective barrier height ΔUe has been enhanced with the provision of the MQB layer **10** in the Si emitter layer **5**.

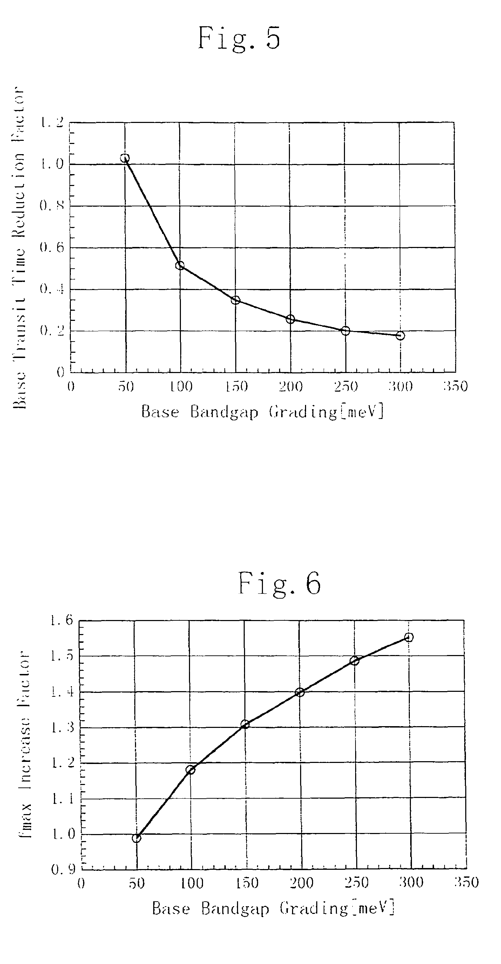

Figure **5** shows the result of calculating the degree to which the base transit time $\tau_B$ of carriers has been reduced (base transit time reduction factor) in the HBT in which the barrier height Δ Ue has been enhanced by the MQB layer **10** and the Ge composition ratio in the SiGe base layer **4** has been graded as shown in Figure **2**, compared with the base transit time in the conventional HBT using the uniform composition base layer. As is represented by the following equations (4) and (5), the base transit $\tau_B$ is a factor directly influencing the current gain cutoff frequency $f_T$, which is higher as the base transit time $\tau_B$ is shorter.

$$f_T = 1/(2\pi \cdot \tau_{EC}) \tag{4}$$

$$\tau_{EC} = \tau_E + \tau_{EB} + \tau_B + \tau_{BC} + \tau_C \tag{5}$$

where $\tau_{BC}$ is the emitter-to-collector transit time of carriers; $\tau_E$ is a time required for the accumulation of minority carriers reversely injected into the emitter; $\tau_{EB}$ is a charge/discharge time for $C_{EB}$; $\tau_{EB}$ is the transit time of majority carriers in the base; $\tau_B$ is a charge/discharge time for $C_{BC}$; and $\tau_C$ is the transit time of electrons in the collector.

In the case of using the uniform composition base layer, however, $\tau_B$ is determined by a diffusion speed as represented by the following equation (6).

$$\tau_B = W_B^2/(2k \cdot T \cdot \mu e/q) \tag{6}$$

where $W_B$ is the thickness of the base layer; $\mu e$ is the mobility of electrons; and T is a temperature.

In the case of using the graded composition base layer, on the other hand, $\tau_B$ is determined by a drift velocity as represented by the following equations (7) and (8).

$$\tau_B = W_B / (\mu e \cdot E) \qquad\qquad (7)$$

$$E = \Delta E_{gr} / q \cdot W_B \qquad\qquad (8)$$

As will be seen from Figure **5**, the base transit time is reduced in accordance with the gradient if a graded composition is imparted to the base layer having the same thickness as the conventional uniform composition base layer. When the gradient of the band gap is 300 meV in the graded composition, the base transit time is reduced to approximately 20% of the base transit time in the uniform composition base.

Figure **6** shows the result of calculating the degree to which the maximum oscillation frequency fmax (fmax increase factor) has been increased in the HBT in which the barrier height $\Delta$Ue has been enhanced with the provision of the MQB layer **10** and the graded composition base layer having an increased thickness for a reduced base resistance $R_B$ is provided, compared with the maximum oscillation frequency fmax in the conventional HBT having the heavily doped uniform composition base layer. It is to be noted that the film thickness of the SiGe base layer has been adjusted to provide a base transit time equal to the base transit time in the heavily doped uniform composition base layer of the conventional HBT. Since the base transit time is reduced by using the graded composition base layer, as shown in the drawing, the thickness of the base layer can be increased as the base gap gradient resulting from the graded composition is increased. As a result, the base resistance $R_B$ is reduced and the maximum oscillation frequency fmax is increased. As shown in the drawing, the maximum oscillation frequency fmax when the band gap gradient resulting from the graded composition is 300 meV is more than 1.5 times higher than the maximum oscillation frequency in the uniform composition base.

In the HBT according to the present embodiment, therefore, the following effects can be derived from the RF characteristics shown in Figure **6** and **5**.

First, the provision of the MQB layer **10** having the barrier height $\Delta$Ue in the Si emitter layer **5** achieves the same effect as achieved when the band discontinuity value $\Delta$Ev of the valence band at the emitter/base junction is substantially increased (see the equation (2)), resulting in an improved current amplification factor $\beta$. In other words, the provision of the MQB layer **10** for suppressing reverse injection of holes from the SiGe base layer **4** into the Si emitter layer **5** reduces the current Jp shown in the equation (2) flowing from the base to the emitter and thereby improves the current amplification factor $\beta$. The effect is achievable whether the emitter/base junction is a heterojunction or not. Consequently, the same effect can also be achieved in a normal bipolar transistor other than a HBT.

Second, since the graded composition has been imparted to the SiGe base layer **4** and the MQB layer **10** is provided in the Si emitter layer **5**, the Ge composition ratio in the SiGe base layer 4 varies such that the band gap in the SiGe base layer **4** gradually decreases from the region of the SiGe base layer **4** in contact with the Si emitter layer **5** toward the region thereof in contact with the Si collector layer **3**, whereby the current gain cutoff frequency $f_T$ is increased. As stated previously, if the base doping concentration is increased to lower the resistance of the uniform composition base layer in the conventional HBT, the quantity of holes reversely injected is increased so that a sufficient current gain is not obtained. By contrast, since the effective barrier height is enhanced with the provision of the MQB layer **10** in the HBT according to the present invention, the effective barrier height is held sufficiently large even when the band discontinuity value of the heterojunction at the emitter/base junction is reduced with the provision of the graded composition base and the base doping concentration is increased, which suppresses reverse injection of holes. Hence, there can be obtained the heavily doped base layer having a graded composition, which has conventionally been unobtainable. As a result, the base transit time of electrons is reduced and the RF characteristics are improved.

Third, since the base transit time is reduced by providing the graded composition base layer, the thickness of the base layer can be increased with the increasing band gap gradient resulting from the graded composition. As a result, the base resistance is reduced and the maximum oscillation frequency fmax is increased.

Fourth, a sufficient current gain obtainable with a low Ge composition ratio achieves the effect of suppressing the occurrence of a dislocation due to a thermal budget during the subsequent process step, which presents a problem when a high Ge composition ratio is used, i.e., the effect of increasing the thermal budget. Briefly, this achieves the effect of providing the device fabrication process with an increased margin as well as increased device reliability.

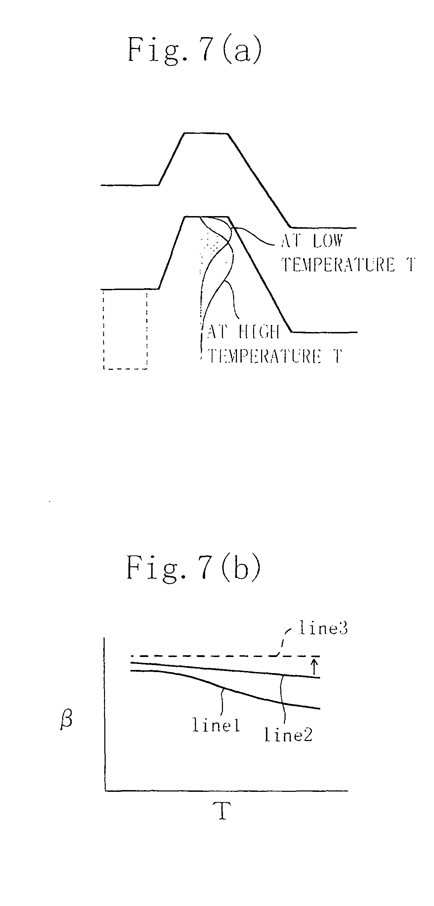

Fifth, the temperature characteristics of the bipolar transistor can also be improved. Specifically, since the distribution of hole concentrations in the valence band of the SiGe layer **4** shifts downwardly at an increased temperature, as shown in Figure **7(a),** the current amplification factor $\beta$ of the bipolar transistor exhibits a general tendency to lower as the temperature T increases, as represented by the lines 1 and 2. The tendency is particularly conspicuous when the band discontinuity $\Delta Ev$ is low. By contrast, the bipolar transistor according to the present invention provides a high current amplification factor $\beta$ even at a high temperature owing to the function of suppressing reverse injection of holes performed by the MQB layer **10**, as represented by the line 3 in Figure **7(b)**.

Thus, by providing the MQB layer **10** in the region of the emitter layer **5** adjacent the emitter/base junction of the heterojunction bipolar transistor, the current gain and RF characteristics of the heterojunction bipolar transistor can be improved.

For the MQB layer **10** to reliably perform the barrier function, the whole MQB layer **10** is preferably disposed externally of a depletion region formed between the emitter and the base at a working voltage. This is because, if the MQB layer **10** has a part located within the depletion region, the function of suppressing reverse injection of holes may not be performed reliably with respect to the part.

In addition, the barrier layer **10b** of the MQB layer **10** which is adjacent to the SiGe base layer **4** is preferably placed in such a position as to prevent the tunneling of holes from the depletion region to the well layer **10a** which is adjacent to the barrier layer **10b,** since the occurrence of the tunneling degrades the function of suppressing reverse injection of holes. Preferably, the MQB layer **10** in the Si emitter layer **5** is at a distance shorter than the diffusion length of holes from the SiGe base layer **4**.

Although the present embodiment has described the improved characteristics of the heterojunction bipolar transistor as a single element, it will easily be appreciated that the HBT according to the present invention may also be used for the bipolar part of a BiCMOS device in which the bipolar transistor and a MOS transistor have been integrated.

Although the present embodiment has described the NPN SiGe HBT by way of example, it will easily be appreciated that the present invention is also applicable to a PNP bipolar transistor. Alternatively, the present invention may also be applied to a normal homojunction bipolar transistor other than the HBT and to a heterojunction bipolar transistor having a multi-level structure consisting of III-V compound semiconductor layers of GaAs, AlGaAs, and the like, as stated previously.

EXAMPLE 1

The present example relates to a heterojunction bipolar transistor characterized in that a heterojunction barrier height (barrier height) is effectively increased by providing, in a region of the emitter adjacent the emitter/base junction, a $\delta$-doped layer having an extremely high carrier concentration to suppress reverse injection of carriers from the base layer and thereby improve the current gain and RF characteristics of the heterojunction bipolar transistor.

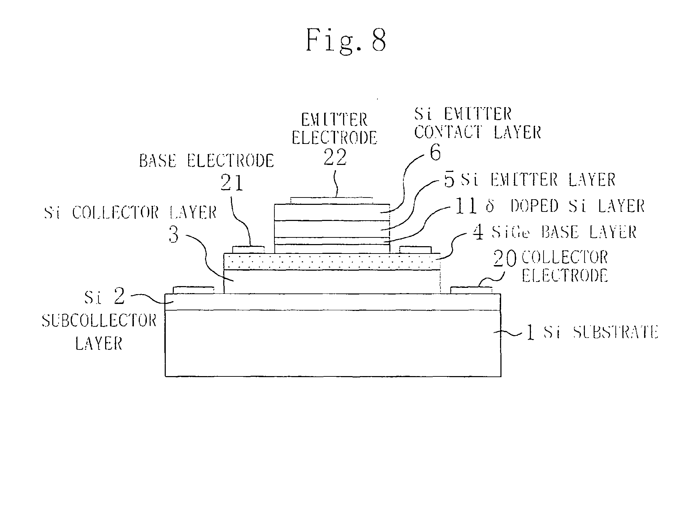

Figure **8** shows a structure of an NPN heterojunction bipolar transistor having the $\delta$-doped layer provided in the emitter layer. As shown in the drawing, there are provided: a high-concentration n-type Si subcollector layer **2** doped with antimony; an n-type Si collector layer **3** doped with antimony; a high-concentration p-type SiGe base layer **4** doped with boron; an n-type Si emitter layer **5** doped with antimony; and a high-concentration n-type Si emitter contact layer **6** doped with antimony that have been stacked sequentially on a Si substrate **1** by MBE. A collector electrode **20**, a base electrode **21**, and an emitter electrode **22** are disposed on the Si subcollector layer **2**, the SiGe base layer **4**, and the Si emitter contact layer **6**, respectively.

The thickness of the high-concentration n-type Si subcollector layer **2** is approximately 500 nm and the concentration of antimony (n-type impurity) in the Si subcollector 2 is approximately $2 \times 10^{19}$ cm$^{-3}$. The thickness of the n-type Si collector layer **3** is approximately 650 nm and the concentration of antimony in the Si collector layer **3** is approximately $1 \times 10^{17}$ cm$^{-3}$. The thickness of the high-concentration p-type SiGe base layer **4** is approximately 50 nm and the concentration of boron (p-type impurity) in the SiGe base layer **4** is approximately $1 \times 10^{19}$ cm$^{-3}$. The thickness of the n-type Si emitter layer **5** is approximately 100 nm and the concentration of antimony in the Si emitter layer **5** is approximately $2 \times 10^{18}$ cm$^{-3}$. The thickness of the high-concentration n-type Si emitter contact layer **6** is approximately 50 nm and the concentration of antimony in the Si emitter contact layer **6** is approximately $2 \times 10^{19}$ cm$^{-3}$. These layers have been formed sequentially by MBE.

A $\delta$-doped Si layer **11** heavily doped with an n-type impurity is provided in a region of the n-type emitter layer **5** adjacent the emitter/base junction portion. The thickness of the $\delta$-doped Si layer **11** is approximately 5 nm and the impurity concentration therein is approximately $1 \times 10^{20}$ cm$^{-3}$. The $\delta$-doped Si layer **11** is disposed in the region of the emitter at a distance of approximately 40 nm from the emitter/base junction portion. Antimony is used as the n-type dopant. The SiGe base layer **4** has a graded composition base structure in which a Ge composition ratio increases substantially continually in the range of 0% to 30% from a region in contact with the Si emitter layer **5** toward a region in contact with the Si collector layer **3**.

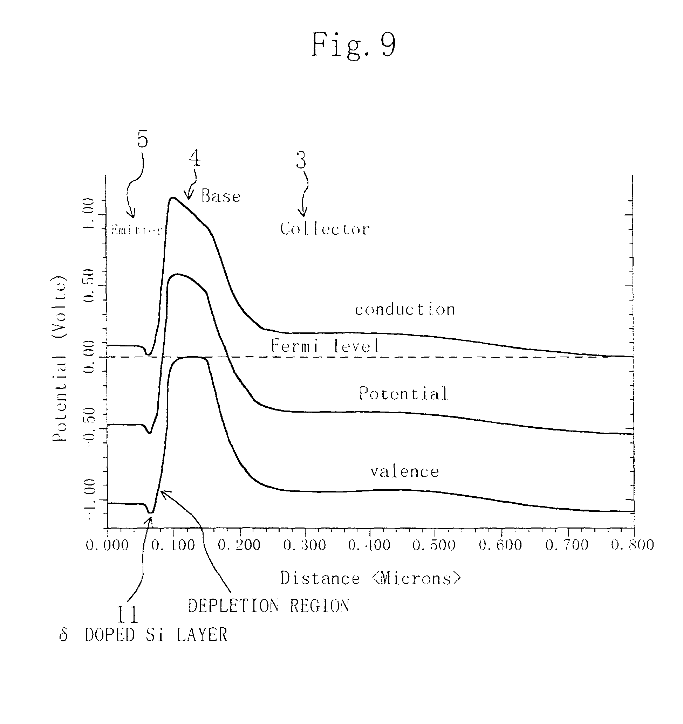

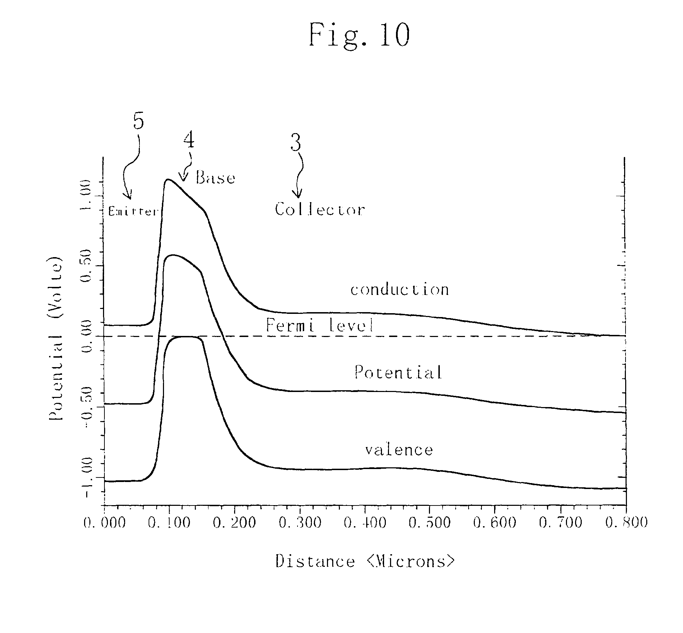

Figure **9** is a band diagram of the NPN heterojunction bipolar transistor, in which the $\delta$-doped Si layer is provided in the emitter layer. Figure **10** is a band diagram of the conventional NPN heterojunction bipolar transistor, in which the $\delta$-doped Si layer is not provided in the Si emitter layer.

As can be seen from Figures **9** and **10**, when the $\delta$-doped Si layer **11** heavily doped with an n-type impurity is provided in the region of the emitter adjacent the emitter/base junction, the band is modulated by the δ-doped Si layer **11** and a potential barrier against holes is formed. From the viewpoint of holes in the SiGe base layer **4**, the provision of the δ-doped Si layer **11** has increased an effective barrier height. Consequently, the reverse injection of the holes into the emitter is suppressed even when the hole concentration in the SiGe base layer **4** is increased, which provides a sufficient current gain. As a result, there can be implemented a HBT which is low in base resistance and extremely high in maximum oscillation frequency fmax.

The potential barrier height enhanced by the δ-doped Si layer **11** is varied by a carrier concentration in the δ-doped Si layer **11**, a carrier concentration in a region of the Si emitter layer **5** on the periphery of the δ-doped Si layer **11**, and an impurity profile in the δ-doped Si layer **11.**

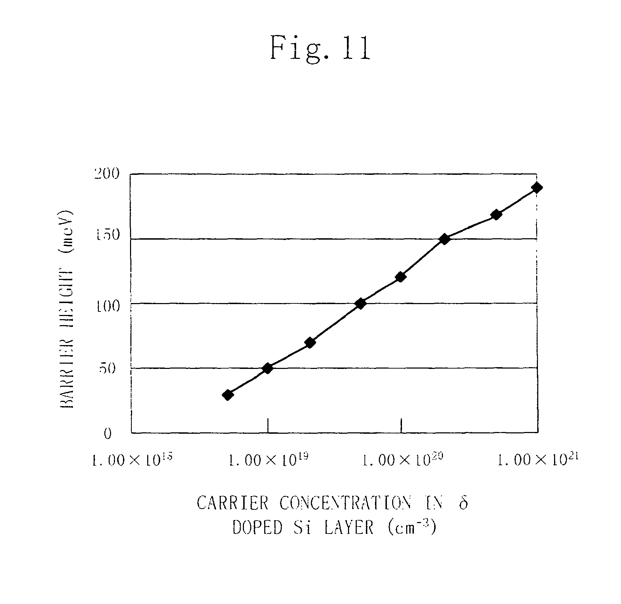

Figure **11** is a graph showing variations in barrier height plotted against the carrier concentration in the δ-doped Si layer (which is the concentration of an n-type impurity in the present embodiment but is the concentration of a p-type impurity in a PNP heterojunction bipolar transistor). It is to be noted that Figure **11** is a graph obtained when the carrier concentration in the Si emitter layer is $1 \times 10^{18}$ cm$^{-3}$. The carrier concentration in the Si emitter layer **5** is $2 \times 10^{18}$ cm$^{-3}$, while the carrier concentration in the δ-doped Si layer **11** is $1 \times 10^{20}$ cm$^{-3}$, so that the carrier concentration ratio therebetween is 1: 50. Thus, the δ-doped Si layer **11** has enhanced the barrier height by approximately 100 meV, which corresponds to a barrier height when the carrier concentration in the δ-doped Si layer **11** is $5 \times 10^{19}$ cm$^{-3}$ in Figure **11**.

For the effect of the example to be exerted more effectively, the carrier concentration in the δ-doped Si layer 11 is preferably $1 \times 10^{19}$ cm$^{-3}$ or higher. In addition, the increment of the barrier height caused by the δ-doped Si layer **11** is preferably by a factor of 10 or more. It will be understood that the barrier height is higher by 50 meV when the carrier concentration in the δ-doped Si layer **11** is ten times as high as the carrier concentration in the Si emitter layer **5**. Hence, the carrier concentration in the δ-doped Si layer **11** is preferably more than ten times higher than the carrier concentration in the Si emitter layer **5**.

By adjusting the carrier concentration in the SiGe base layer **4** to be higher than the carrier concentration in the Si emitter layer **5**, it is also possible to desirably reduce the base resistance and suppress a capacitance increase at the PN junction portion.

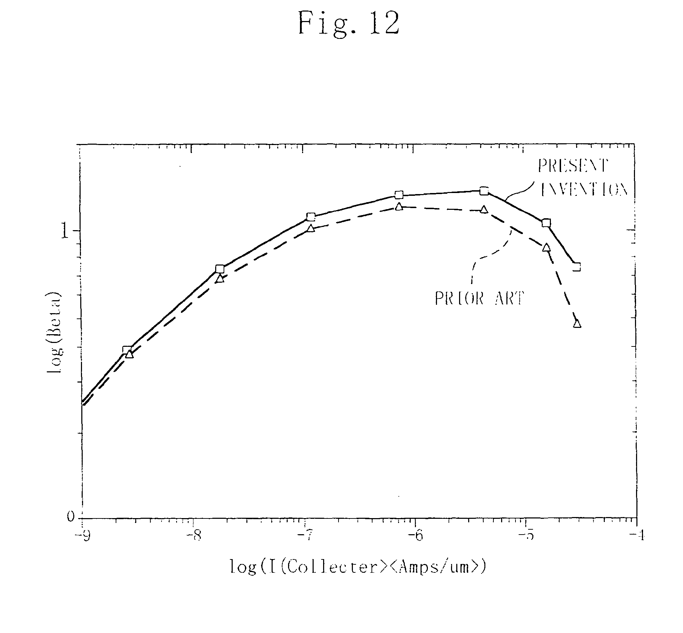

Figure **12** is a view showing the relationship (represented by the solid curve) between the current amplification factor β and a collector current in the NPN heterojunction bipolar transistor in which the δ-doped Si layer **11** is provided in the emitter layer and the relationship (represented by the dashed curve) between the current amplification factor β and a collector current in the conventional NPN heterojunction bipolar transistor in which the δ-doped Si layer is not provided in the emitter layer. As shown in the drawing, the current amplification factor β has been improved with the provision of the δ-doped Si layer **11** in the Si emitter layer **5**. The difference in current amplification factor β between the two heterojunction bipolar transistors is particularly conspicuous in a region with a large collector current. Since a high current amplification factor β is obtained in the heterojunction bipolar transistor even with such a large collector current, the maximum value $f_{Tmax}$ of the current cutoff frequency is increased by about 25% compared with the maximum value $f_{Tmax}$ in the heterojunction bipolar transistor without a δ -doped Si layer.

If the Ge composition ratio in the SiGe base layer **4** is increased, a dislocation may occur depending on the critical film thickness of SiGe. The respective critical film thicknesses for $Si_{0.8}Ge_{0.2}$, $Si_{0.7}Ge_{0.3}$, and $Si_{0.6}Ge_{0.4}$ when the underlie is Si are approximately 180 nm, 56 nm, and 25 nm.

In increasing the critical film thickness, it is effective to use $Si_{1-x-y}Ge_xC_y$ to compose the base layer. By adjusting the Ge composition to 40% or more and adding a slight amount of C (on the order of several percentage) thereto, a strained lattice can be alleviated without greatly varying the magnitude of the band discontinuity value ΔEv of the emitter/base junction, which increases the critical film thickness of the base layer. By thus composing the base layer of $Si_{1-x-y}Ge_x$-$C_y$, a larger band discontinuity value ΔEv can be obtained without exceeding the critical film thickness.

Next, the δ-doped Si layer **11** is provided in the Si emitter layer **5** to enhance the effective barrier height. As shown in Figure **9**, the effect of improving the RF characteristics of the HBT having the SiGe graded composition base layer **4** is the same as illustrated in the first embodiment with reference to Figures **5** and **6**.

From the foregoing, there have been derived the following effects that can be achieved by the heterojunction bipolar transistor (HBT).

First, the provision of the δ-doped Si layer **11** for effectively enhancing the barrier height in the Si emitter layer achieves the same effect as achieved when the band discontinuity value ΔEv of the valence band at the emitter/base junction is substantially increased (see the equation (2)), resulting in an improved current amplification factor β. In other words, the provision of the δ-doped Si layer **11** for suppressing reverse injection of holes from the SiGe base layer **4** into the Si emitter layer **5** reduces the current Jp shown in the equation (2) flowing from the base to the emitter and thereby improves the current amplification factor β. The effect is achievable whether the emitter/base junction is a heterojunction or not. Consequently, the same effect can also be achieved in a normal bipolar transistor other than a HBT.

Second, since the graded composition has been imparted to the SiGe base layer **4** and the δ-doped Si layer **11** is provided in the Si emitter layer **5**, the Ge composition ratio in the SiGe base layer **4** varies such that the band gap in the SiGe base layer **4** gradually decreases from the region of the SiGe base layer **4** in contact with the Si emitter layer **5** toward the region thereof in contact with the Si collector layer **3**, whereby the current gain cutoff frequency $f_T$ is increased. As stated previously, if the base doping concentration is increased to lower the resistance of the uniform composition base layer in the conventional HBT, the quantity of holes reversely injected is increased so that a sufficient current gain is not obtained. By contrast, since the effective barrier height at the heterojunction portion is increased with the provision of the δ-doped Si layer **11** in the HBT, the effective barrier height is held sufficiently large even when the band discontinuity value of the heterojunction at the emitter/base junction is reduced with the provision of the SiGe graded composition base layer **4** and the base doping concentration is increased, which suppresses reverse injection of holes. Hence, there can be obtained the heavily doped base layer having a graded composition, which has conventionally been unobtainable. As a result, the base transit time of electrons is reduced and the RF characteristics are improved.

Third, since the base transit time is reduced by providing the graded composition base layer, the thickness of the base layer can be increased. As a result, the base resistance is reduced and the maximum oscillation frequency fmax is increased.

Fourth, the fact that a sufficient current gain can be obtained even when the Ge composition ratio is low indicates that a dislocation caused by a thermal budget during the subsequent process step, which presents a problem when a high Ge composition ratio is used, can be suppressed. In the conventional HBT using the uniform composition base, it is required in doping the SiGe base layer with a high-concentration impurity to increase the Ge composition ratio in the SiGe base layer, so that the difference in lattice constant between the emitter layer and the Si base layer is increased disadvantageously to reduce the critical film thickness at which a dislocation is caused by the difference in lattice constant. However, if the effective barrier height is enhanced with the provision of the δ-doped Si layer **11**, satisfactory RF characteristics are achieved without increasing the Ge composition ratio in the SiGe base layer **4**. The sufficient current gain obtainable with a low Ge composition ratio also achieves the effect of suppressing the occurrence of a dislocation due to the thermal budget during the subsequent process step, which presents a problem when a high Ge composition ratio is used, i.e., the effect of increasing the thermal budget. Briefly, this achieves the effect of providing the device fabrication process with an increased margin as well as increased device reliability.

Fifth, the temperature characteristic of the bipolar transistor can also be improved. Specifically, since the distribution of hole concentrations in the valence band of the SiGe layer **4** shifts downwardly at an increased temperature, the current amplification factor β of the bipolar transistor exhibits a tendency to lower as the temperature T increases. The tendency is particularly conspicuous when the band discontinuity ΔEv is low. By contrast, the bipolar transistor according to the present example provides a high current amplification factor β even at a high temperature owing to the function of suppressing reverse injection of holes performed by the δ-doped Si layer **11**, as represented by the line 3 in Figure **7(b)**.

Thus, by providing the δ-doped Si layer **11** in the region of the emitter layer **5** adjacent the emitter/base junction of the heterojunction bipolar transistor, the current gain and RF characteristics of the heterojunction bipolar transistor can be improved.

For the δ-doped Si layer **11** to reliably perform the barrier function, the whole δ-doped Si layer **11** is preferably disposed externally of a depletion region formed between the emitter and the base at a working voltage and the δ-doped Si layer **11** is preferably adjacent to the depletion region. This is because, if the δ-doped Si layer **11** has a part located within the depletion region, the barrier height is reduced and the function of suppressing reverse injection of holes may be degraded. Preferably, the δ-doped Si layer **11** in the Si emitter layer **5** is at a distance shorter than the diffusion length of hole from the SiGe base layer **4**.

Although the present example has described the improved characteristics of the heterojunction bipolar transistor as a single element, it will easily be appreciated that the HBT according to the present example may also be used for the bipolar part of a BiCMOS device in which the bipolar transistor and a MOS transistor have been integrated.

Although the present example has described the NPN SiGe HBT by way of example, it will easily be appreciated that the present example is also applicable to a PNP bipolar transistor. Alternatively, the present example may also be applied to a normal homojunction bipolar transistor other than the HBT and to a heterojunction bipolar transistor having a multi-level structure consisting of III-V compound semiconductor layers of GaAs, AlGaAs, and the like, as stated previously.

EMBODIMENT 2

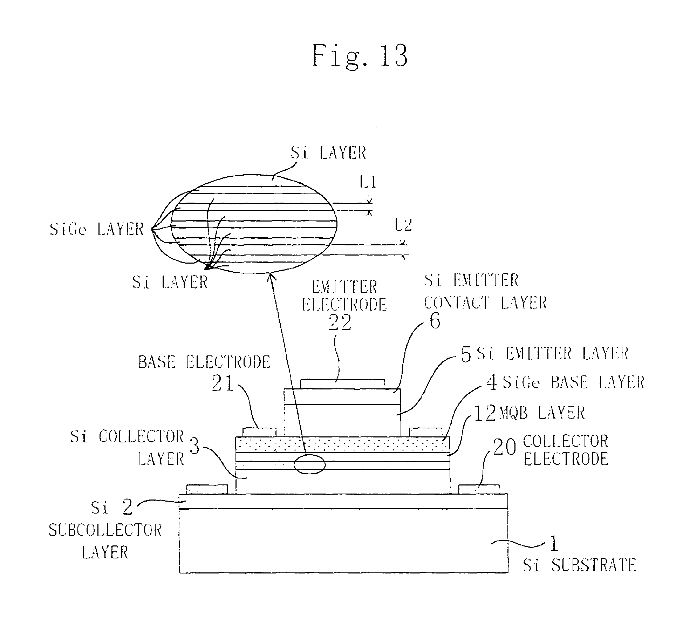

Figure **13** is a cross-sectional view showing a structure of an NPN heterojunction bipolar transistor having a multi-quantum barrier composed of a Si/SiGe superlattice provided in the collector layer according to the present embodiment. As shown in the drawing, there are provided: a high-concentration n-type Si subcollector layer **2** doped with arsenic; an n-type Si collector layer **3** doped with arsenic; a high-concentration p-type SiGe base layer **4** doped with boron; an n-type Si emitter layer **5** doped with arsenic; and a high-concentration n-type Si emitter contact layer **6** doped with arsenic that have been stacked sequentially on a Si substrate **1**. A collector electrode **20**, a base electrode **21**, and an emitter electrode **22** are disposed on the Si subcollector layer **2**, the SiGe base layer **4**, and the Si emitter contact layer **6**, respectively.

The thickness of the high-concentration n-type Si subcollector layer **2** is approximately 500 nm and the concentration of arsenic (n-type impurity) in the Si subcollector 2 is approximately $2 \times 10^{19}$ cm$^{-3}$. The thickness of the n-type Si collector layer **3** is approximately 650 nm and the concentration of the Si collector layer **3** is approximately $1 \times 10^{17}$ cm$^{-3}$. The thickness of the high-concentration p-type SiGe base layer **4** is approximately 50 nm and the concentration of boron (p-type impurity) in the SiGe base layer **4** is approximately $1 \times 10^{19}$ cm$^{-3}$. The thickness of the n-type Si emitter layer **5** is approximately 100 nm and the concentration of arsenic in the Si emitter layer **5** is approximately $2 \times 10^{18}$ cm$^{-3}$. The thickness of the high-concentration n-type Si emitter contact layer **6** is approximately 50 nm and the concentration of arsenic in the Si emitter contact layer **6** is approximately $2 \times 10^{19}$ cm$^{-3}$. These layers have been stacked sequentially by MBE.

A MQB layer **12** as a multi-quantum barrier portion having a superlattice structure composed of extremely thin Si and SiGe that have been alternately stacked is provided in a region of the Si collector layer **3** adjacent the collector/base junction portion. The MQB layer **12** has such a structure that the compositions and film thicknesses thereof have been adjusted to reflect an incident wave of holes injected from the SiGe base layer **4** into the Si collector layer **3** and provide a phase in which the incident wave and a reflected wave intensify each other. Specifically, the MQB layer **12** has a multilayer structure consisting of well layers **12a** each composed of a SiGe layer with a thickness of L1 and barrier layers **12b** each composed of a Si layer with a thickness of L2. The respective thicknesses and compositions of the well layers **12a** and the barrier layers **12b** are determined to satisfy the relationship represented by the following equation (3), similarly to the first embodiment.

$$\left. \begin{array}{c} \dfrac{\sqrt{2m_1 * E}}{h} \cdot L_1 = \dfrac{2m-1}{4} \\[3em] \dfrac{\sqrt{2m_2 * (E - \Delta Ev)}}{h} \cdot L_2 = \dfrac{2n-1}{4} \end{array} \right\} \quad \ldots\ldots \quad (3)$$

m1*: effective mass of holes in SiGe layer (well layer)
m2*: effective mass of holes in Si layer (barrier layer)
L1: thickness of SiGe layer (well layer)
L2: thickness of Si layer (barrier layer)
E: energy of incident holes
$\Delta$Ev: valence band discontinuity value at Si/SiGe heterojunction
h : Planck's constant
m, n: integers

Specifically, the MQB layer **12** according to the present embodiment is composed of a superlattice layer constructed of five pairs of the barrier layers **12b** each formed of Si having a thickness of 1.5 nm and the well layers **12a** each formed of $Si_{0.8}Ge_{0.2}$ having a thickness of 1.5 nm. In this case, an effective barrier height enhanced by the MQB layer **12** is approximately 130 meV.

On the other hand, the SiGe base layer **4** has a graded composition base structure in which a Ge composition ratio increases substantially continually from 0% to 20% from a region in contact with the Si emitter layer **5** toward a region in contact with the Si collector layer **3**. Accordingly, the barrier height sensed by holes in the SiGe layer **4** is 280 meV, which is the sum of 150 meV corresponding to the amount of valence band offset occurring at the base/collector heterojunction composed of $Si/Si_{0.8}Ge_{0.2}$ and 130 meV corresponding to the effectively enhanced barrier height of the MQB layer **12**. This achieves a sufficient reduction in the minority carriers injected from the SiGe base layer **4** and accumulated in the Si collector layer **4**.

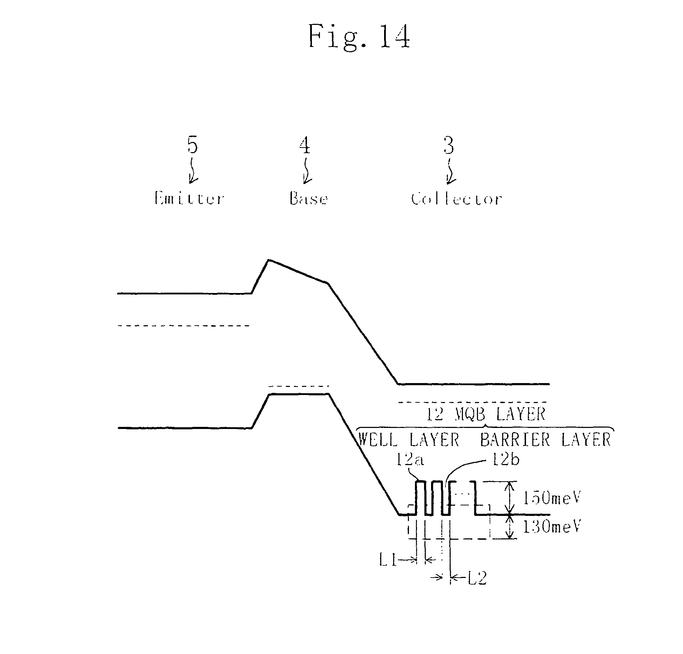

Figure **14** is a band diagram of the NPN heterojunction bipolar transistor having the multi-quantum barrier layer composed of the Si/SiGe superlattice and provided in the Si collector layer **3** according to the present embodiment. As shown in the drawing, the multi-quantum barrier layer consisting of the five pairs of Si barrier layers **12b** and $Si_{0.8}Ge_{0.2}$ well layers **12a** is provided in a region of the Si collector layer **3** adjacent the collector/base junction. A potential barrier indicated by the broken lines in Figure **14** is formed due to the existence of the MQB layer **12**. The potential barrier operates to reflect holes likely to flow from the SiGe base layer **4** into the Si collector layer **3**, which has enhanced an effective height sensed by the holes likely to flow from the SiGe base layer **4** by approximately 130 meV. The enhanced effective barrier height suppresses injection of the holes into the Si collector layer **3** so that the quantity of minority carriers accumulated in the Si collector layer 3 is reduced and the operating speed is increased.

The model for calculating the barrier height ΔUe enhanced by the MQB layer **12** provided in the collector is similar to the model for calculating the barrier height ΔUe in the case where the MQB layer is provided in the emitter according to the first embodiment, which is shown in Figure **3**. Specifically, the respective band discontinuity values ΔEv of the valence bands at the individual heterojunctions between the well layers **12a** and the barrier layers **12b** that have been calculated for the three structures of $Si/Si_{0.8}Ge_{0.2}$, $Si/Si_{0.7}Ge_{0.3}$, and $Si/Si_{0.6}Ge_{0.4}$ are 150 meV, 225 meV, and 300 meV. It is to be noted that, since each of the well layers **12a** and barrier layers **12b** has a thickness of 1.5 nm in the present embodiment, the values obtained in the present embodiment are different from the values of the corresponding parts shown in Figure **3**.

The result of calculating the barrier heights ΔUe enhanced by the MQB layer **12** in response to variations in the number of the atomic monolayers of well layers **12a** and barrier layers **12b** is also as shown in Figure **4**.

In order to enhance the barrier height ΔUe when SiGe is used in the well layer **12a** of the MQB layer **12**, it is also necessary in the present embodiment to further increase the Ge composition ratio in the well layers **12a**, similarly to the first embodiment. However, the increased Ge composition ratio may cause a dislocation depending on the critical film thickness of SiGe. The respective critical film thicknesses for $Si_{0.8}Ge_{0.2}$, $Si_{0.7}Ge_{0.3}$, and $Si_{0.6}Ge_{0.4}$ when the underlie is Si are approximately 180 nm, 56 nm, and 25 nm.

In increasing the critical film thickness, it is effective to use $Si_{1-x-y}Ge_xC_y$ and Si to compose the well layers **12a** and barrier layers **12b** of the MQB layer **12**, respectively. By adjusting the Ge composition to 40% or more and adding a slight amount of C (on the order of several percentage) thereto, a strained lattice can be alleviated without greatly varying the magnitude of the band discontinuity value ΔEv at the collector/base junction, which increases the critical film thickness of the well layer **12a**. By thus composing the MQB layer **12a** of $Si_{1-x-y}Ge_xC_y$, a larger band discontinuity value ΔEv can be obtained without exceeding the critical film thickness, which effectively suppresses injection of holes from the SiGe base layer **4** into the Si collector layer **3**.

By thus providing the MQB layer **12** in the region of the Si collector layer **3** adjacent the base/collector junction of the heterojunction bipolar transistor, it becomes possible to effectively enhance the height of the heterojunction barrier at the base/collector heterojunction and thereby suppress injection of minority carriers from the SiGe base layer **4** into the Si collector layer **3**. As a result, the quantity of minority carriers accumulated in the Si collector layer **3** is reduced and the operating speed of the bipolar transistor can be increased.

Although the present embodiment has described the improved characteristics of the heterojunction bipolar transistor as a single element, it will easily be appreciated that the HBT according to the present invention may also be used for the bipolar part of a BiCMOS device in which the bipolar transistor and a MOS transistor have been integrated.

It will easily be appreciated that, if an integrated circuit uses as a component the base/collector PN junction of a heterojunction bipolar transistor having a multi-quantum barrier against minority carriers provided in a collector, as shown in the present embodiment, the speed of the integrated circuit is increased.

EMBODIMENT 3

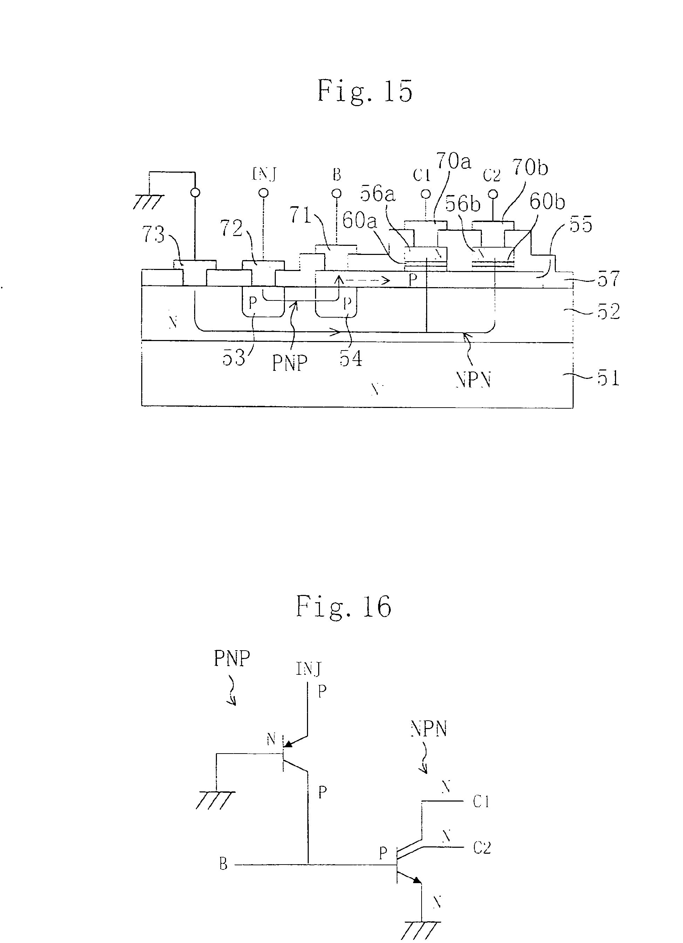

Figure **15** is a cross-sectional view of an I²L element comprising a Si/SiGe heterojunction bipolar transistor having a MQB layer provided in a collector layer as shown in the second embodiment. Figure **16** is an electric circuit diagram showing a circuit equivalent to the I²L element.

A description will be given below to a structure of the I²L element shown in Figure **15** with reference to Figure **16**. The I²L element according to the present embodiment comprises: an n'-type semiconductor region **51**; an n-type Si common diffusion layer **52** disposed on the semiconductor region **51** to function as the base layer of a PNP bipolar transistor and as the emitter layer of an NPN bipolar transistor; a Si emitter layer **53** and a Si collector **54** of the PNP bipolar transistor formed by introducing a p-type impurity into the Si common diffusion layer **52**; a p-type SiGe base layer **55** of the I²L element disposed on the Si common diffusion layer **52**; two n-type Si collector layers **56a** and **56b** of the NPN bipolar transistor disposed on the SiGe base layer **55**; an insulating layer **57** covering the entire substrate; two collector electrodes **70a** and **70b** of the NPN bipolar transistor for contact with the Si collector layers **56a** and **56b** through the insulating layer **57**; a base electrode **71** of the I²L element for contact with the SiGe base layer **55** through the insulating layer **57**; an injection electrode **72** of the I²L element for contact with the Si emitter layer **53** of the PNP bipolar transistor through the insulating layer **57**; and a ground electrode **73** for contact with the Si common diffusion layer **52** through the insulating layer **57**. It is to be noted that the SiGe base layer **55** of the I²L element functions as the base layer of the NPN bipolar transistor and as the collector contact layer of the PNP bipolar transistor. The I²L element is structured such that a current for driving the PNP transistor is injected into the injection electrode **72**, an input signal to the I²L element is input to the base electrode **71**, and an output signal from the I²L element is obtained from each of the collector electrodes **70a** and **70b** connected to a power source voltage via a circuit (not shown). The arrows shown in Figure **15** represent respective current flows in the PNP and NPN bipolar transistors.

The concentration of arsenic (n-type impurity) in each of the Si collector layers **56a** and **56b** is approximately $1 \times 10^{17}$ cm$^{-3}$. In a surface region of each of the Si collector layers **56a** and **56b**, there is provided a contact layer doped with arsenic at a high concentration (approximately $1 \times 10^{20}$ cm$^{-3}$), though it is not shown. The concentration of boron (p-type impurity) in the SiGe base layer **55** is approximately $2 \times 10^{18}$ cm$^{-3}$. The concentration of boron in the Si emitter layer **53** is approximately $1 \times 10^{19}$ cm$^{-3}$. The concentration of boron in the Si collector layer **54** is approximately $1 \times 10^{19}$ cm$^{-3}$. The concentration of phosphorus in the Si common diffusion layer **52** is approximately $1 \times 10^{18}$ cm$^{-3}$.

The following is the operation of the I$^2$L element. When a low-voltage signal "L" is input to the base electrode **71**, the current flow in the PNP bipolar transistor becomes as indicated by the solid arrow in the drawing, so that the base voltage of the NPN bipolar transistor is lowered to turn OFF the NPN bipolar transistor. Accordingly, the voltage at each of the collector electrodes **70a** and **70b** connected to the power-source voltage becomes high so that a signal "H" is output. When the high-voltage signal "H" is input to the base electrode **71**, on the other hand, the current flow in the PNP bipolar transistor becomes as indicated by the dashed arrow so that the base voltage of the NPN bipolar transistor becomes high to turn ON the NPN transistor. As a result, the voltage at each of the collector electrodes 70a and 80b becomes low so that the signal "L" is output. In short, the I$^2$L element functions as a NOT circuit (inverter).

The I$^2$L element according to the present embodiment is characterized in that the same MQB layers **60a** and **60b** as formed in the first embodiment are formed in the two Si collector layers **56a** and **56b**, respectively.

Such an I$^2$L element performs the same function as performed by an inverter composed of the PFET and NFET of a CMOS device. Since the I$^2$L element does not require an isolation film as required by the CMOS device, it has the advantage of suitability for higher integration. However, a conventional I$^2$L element has the drawback of an elongated time required for ON/OFF switching due to minority carriers accumulated in the collector layer of the NPN bipolar transistor. For this reason, the I$^2$L element is not frequently used in a semiconductor integrated circuit.

By contrast, since the structure of the I$^2$L element according to the present embodiment has the MQB layers **60a** and **60b** provided in the Si collector layers **56a** and **56b**, respectively, for preventing injection of holes from the base, it is free from the elongated ON/OFF switching time due to holes (minority carriers) accumulated in the Si collector layers **56a** and **56b** and performs a high-speed operation intrinsic to a bipolar transistor. Hence, the I$^2$L element has the advantages of suitability for higher integration and a high-speed operating property, which allows the use of the I$^2$L element as an inverter in a Si heterojunction device. In addition, power consumption is satisfactorily low compared with the power consumption of a MOS device.

The I$^2$L element according to the present embodiment further has the following structural advantages. In contrast to a CMOS device, the NPN bipolar transistor on the output side of the I$^2$L element has a so-called collector top structure in which the Si collector layers **56a** and **56b** are disposed above the SiGe base layer **55**. The collector top structure is suitable for the provision of the MQB layers **60a** and **60b** formed by epitaxial growth. More specifically, the I$^2$L element has the collector top structure in which the collector layer is formed above the base layer because of a plurality of collector outputs, while a normal Si/SiGe HBT generally has an emitter top structure in which an emitter layer is formed above a SiGe base layer formed by epitaxial growth. This is because, in the I$^2$L element, the emitter and base regions of the NPN bipolar transistor also serve as the base and collector regions of the PNP bipolar transistor as a constant current source, so that the base and collector layers of the NPN transistor are eventually formed by epitaxial growth above the emitter layer.

From this viewpoint, it can also be said that the I$^2$L element having the MQB layers provided in a region of the collector adjacent the base/collector junction portion of the HBT has an easy-to-fabricate structure.

Although the present embodiment has described the I$^2$L element using the NPN SiGe HBT, it is also possible to compose the I$^2$L element by using a PNP SiGe HBT.

The I$^2$L element according to the present embodiment may be a heterojunction bipolar transistor having a multi-level structure consisting of III-V compound semiconductor layers of GaAs, AlGaAs, and the like.

Although the present embodiment has the two collector layers, it may also have a single collector layer or three or more collector layers.


EMBODIMENT 4

A description will be given below to a semiconductor device according to the third embodiment, in which the base/collector junction portion of a bipolar transistor can be used as a diode.

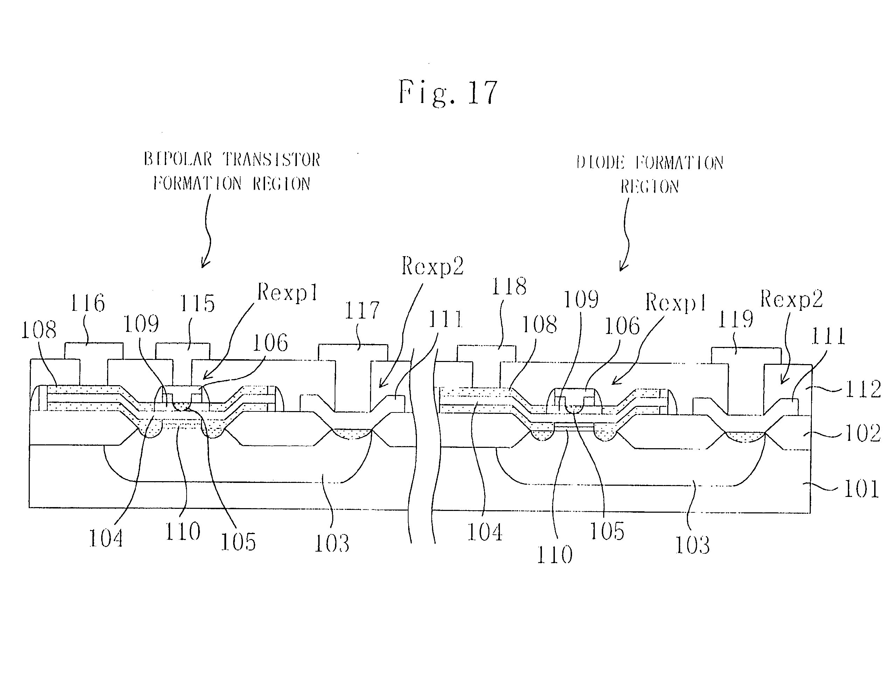

As shown in Figure **17**, the semiconductor device according to the present embodiment has a bipolar transistor formation region and a diode formation region. The bipolar transistor formation region and the diode formation region have common members, except for electrodes, which are formed by common process steps. Specifically, there are provided: a Si collector layer **103**; a p-type SiGe base layer **104** formed on the Si collector layer **103**; an n'-type Si emitter layer **105** formed on the SiGe base layer **104**; an emitter withdrawn electrode **106** composed of polysilicon for contact with the Si emitter layer **105**; and a MQB layer **110** formed on a region of the Si collector layer **103** underlying a first exposed region **Rexp1**, each of which is located in an active region composed of the first and second exposure regions **Rexp1** and **Rexp2** of the Si substrate **101** surrounded by LOCOS films **102** and of the internal region of the substrate interposed between the exposed regions **Rexp1** and **Rexp2**. A first Si single-crystal film including the Si collector layer **103** is formed by epitaxial growth over the first exposed region **Rexp1** and the surrounding LOCOS films, which is thoroughly provided with a superlattice multi-layer structure common to the MQB layer **110**. A p-type impurity has been introduced into the first Si single-crystal film except for the region thereof immediately under the emitter withdrawn electrode **106** by ion implantation using the emitter withdrawn electrode **106** as a mask. The SiGe base layer **104** is formed over the first Si single-crystal film and a second Si single-crystal film is further formed by epitaxial growth over the SiGe base layer **104**. The second Si single-crystal film except for the region thereof immediately under the emitter withdrawn electrode **106** forms a silicide layer **108**, while the region immediately under the emitter withdrawn electrode **106** forms a Si cap layer **109**. The foregoing Si emitter layer **105** has been formed by introducing, by diffusion, a high-concentration n-type impurity into the Si cap layer **109** from the emitter withdrawn electrode **106**. A collector withdrawn electrode **111** composed of polysilicon for contact with the Si collector layer **103** is formed over the second exposed region **Rexp2** and the surrounding LOCOS films **102**. An insulating film **112** composed of a silicon oxide film is formed on the substrate.

The concentration of arsenic (n-type impurity) in the Si collector layer **103** is approximately $1 \times 10^{17}$ cm$^{-3}$. The thickness of the SiGe base layer **104** is approximately 50 nm and the concentration of boron (p-type impurity) in the SiGe base layer **104** is approximately $1 \times 10^{19}$ cm$^{-3}$. The thickness of the Si cap layer **109** is approximately 100 nm and the concentration of arsenic in the Si emitter layer **105** of the Si cap layer **109** is approximately $2 \times 10^{18}$ cm$^{-3}$.

The present embodiment is characterized in that the diode has no electrode equivalent to the emitter electrode, while the NPN bipolar transistor has an Al emitter electrode **115** connected to the emitter withdrawn electrode **106**, an Al base electrode **116** connected to the silicide layer provided on the Si base layer **104**, and an Al collector electrode **117**, each of which is formed on the insulating layer **112**. Briefly, only the Al anode **118** equivalent to the base electrode **116** of the NPN bipolar transistor and the Al cathode **119** equivalent to the collector electrode of the NPN bipolar transistor are provided. Thus, the diode according to the present embodiment has only the anode and the cathode connected to the base and to the collector, respectively, without an electrode connected to the emitter, while having the same emitter, base, and collector structures as the NPN bipolar transistor.

The semiconductor device according to the present embodiment comprises the diode having a heterojunction in addition to the heterojunction bipolar transistor exerting the same effect as exerted in the third embodiment. In the diode also, there is provided a MQB layer in a region of the Si collector layer **103** connected to the cathode electrode **119** adjacent the junction portion between the Si collector layer **103** and the SiGe base layer **104**, so that the operating speed is increased by suppressing the accumulation of holes.

Although the present embodiment has described the NPN SiGe HBT by way of example, it will easily be appreciated that the present invention is also applicable to the PNP bipolar transistor. As stated previously, the present invention is also applicable to a normal homojunction bipolar transistor other than a HBT or to a heterojunction bipolar transistor having a multi-layer structure consisting of III-V compound semiconductor layers of GaAs, AlGaAs, and the like.

**Claims**

1. A bipolar transistor comprising an emitter layer (5), a base layer (4), and a collector layer (3), said bipolar transistor having
a multi-quantum barrier portion being provided in said emitter layer (5) and composed of a plurality of barrier layers (10b) and well layers (10a) alternately stacked to perform the function of reflecting an incident wave of minority carriers in the emitter layer (5) injected from said base layer (4) and provide such a phase that the incident wave of said minority carriers and a reflected wave of said minority carriers intensify each other,
**characterized in that**
the band in said emitter layer containing said multi-quantum barrier portion, of the majority carriers, has a substantially negligible band discontinuity value.

2. The bipolar transistor according to claim 1, wherein the barrier layers (10b) and well layers (10a) of said multi-quantum barrier portion are composed of respective semiconductor materials having different band gaps.

3. The bipolar transistor according to claim 1, wherein said base layer (4) is strained.

4. The bipolar transistor according to claim 1, wherein said emitter layer (5) and said base layer (4) are composed of respective semiconductor materials having different band gaps and
a band gap between a valence band and a conduction band in said base layer (4) has a portion gradually decreasing from a region of said base layer (4) in contact with said emitter layer (5) toward a region of said base layer (4) in contact with said collector layer (3).

5. The bipolar transistor according to claim 1, wherein said base layer (4) is composed of a semiconductor containing at least silicon and germanium.

6. The bipolar transistor according to claim 5, wherein said multi-quantum barrier portion has a superlattice structure composed of $Si_{1-x}Ge_x$/Si multiple layer.

7. The bipolar transistor according to claim 5, wherein said multi-quantum barrier portion has a superlattice structure composed of a $Si_{1-x-y}Ge_xC_y$/Si multiple layer.

8. The bipolar transistor according to claim 1, wherein said multi-quantum barrier portion is disposed in a region of said emitter layer (5) exterior to a depletion region formed between said emitter layer (5) and said base layer (4) at a working voltage when said transistor is operating.

9. The bipolar transistor according to claim 8, wherein said barrier layer (10b) at the end of said multi-quantum barrier portion closer to said base layer (4) is disposed in such a position as to prevent the tunneling of the carriers from the depletion region formed between said emitter layer (5) and said base layer (4) to the well layer (10a) adjacent to the barrier layer (10b) at the end of said multi-quantum barrier portion closer to said base layer (4).

10. A semiconductor device comprising a bipolar transistor comprising an emitter layer (5,52,105), a base layer (4,55,104), and a collector layer (3,56,103), said bipolar transistor having,
a multi-quantum barrier portion being provided in said collector layer (3,56,103) and composed of a plurality of barrier layers (12b) and well layers (12a) alternately stacked to perform the function of reflecting an incident wave of minority carriers in the collector layer (3,56,103) injected from said base layer (4,55,104) and provided such a phase that the incident wave and a reflected wave intensify each other,
**characterized in that**
the band in said collector layer containing said multi-quantum barrier portion, of the majority carriers, has a substantially negligible band discontinuity value.

11. The semiconductor device according to claim 10, wherein the barrier layers (12b) and well layers (12a) of said multi-quantum barrier portion are composed of respective semiconductor materials having different band gaps.

12. The semiconductor device according to claim 10, wherein said base layer (4,55,104) is strained.

13. The semiconductor device according to claim 10, wherein said base layer (4,55,104) is composed of a semiconductor containing at least silicon and germanium.

14. The semiconductor device according to claim 13, wherein said multi-quantum barrier portion has a superlattice structure composed of a $Si_{1-x}Ge_x$/Si multiple layer.

15. The semiconductor device according to claim 13, wherein said multi-quantum barrier portion has a superlattice structure composed of a $Si_{1-x-y}Ge_xC_y$/Si multiple layer.

16. The semiconductor device according to claim 10, wherein said multi-quantum barrier portion is disposed in a region of said collector layer (3,56,103) exterior to a depletion region formed between said emitter layer (5,52,105)and said base layer (4,55,104) at a working voltage when said transistor is operating.

17. The semiconductor device according to claim 16, wherein the barrier layer (12b) at the end of said multi-quantum barrier portion closer to said base layer (4,55,104) is disposed in such a position as to prevent the tunneling of the carriers from the depletion region formed between said collector layer (3,56,103) and said base layer (4,55,104) to the well layer (12a) adjacent to the barrier layer at the end of said multi-quantum barrier portion closer to said base layer (4,55,104).

18. The semiconductor device according to claim 10, further comprising an element having, as components, two regions having the same structure as a base (104)/collector (103) junction of said bipolar transistor.

**19.** The semiconductor device according to claim 18, wherein said element is a diode.

**20.** The semiconductor device according to claim 10, further comprising:

> another bipolar transistor comprising a collector layer disposed in a region used commonly by the base layer of said bipolar transistor, a base layer disposed in a region used commonly by the collector layer of said bipolar transistor, and an emitter layer,
> said semiconductor device functioning as an $I^2L$ element.

**21.** The semiconductor device according to claim 20, further comprising:

> at least one other collector layer connected to the base layer of said bipolar transistor, said semiconductor device having
> another multi-quantum barrier portion being provided in said one other collector layer and composed of a plurality of barrier layers and well layers alternately stacked to perform the function of reflecting an incident wave of carriers injected from said base layer and provide such a phase that the incident wave and a reflected wave intensify each other.

**Patentansprüche**

**1.** Ein bipolarer Transistor umfassend eine Emitterschicht (5), eine Basisschicht (4) und eine Kollektorschicht (3), wobei besagter bipolarer Transistor
einen Multi-Quanten-Barriereabschnitt aufweist, welcher in besagter Emitterschicht (5) zur Verfügung gestellt wird und aus einer Vielzahl von abwechselnd gestapelten Barriere-Schichten (10b) und Well-Schichten (10a) besteht, um die Funktion des Reflektierens einer einfallenden Welle von Minoritäts-Ladungsträgern in der Emitterschicht (5), injiziert von besagter Basisschicht (4) auszuführen und solch eine Phase zur Verfügung zu stellen, dass die einfallende Welle von besagten Minoritäts-Ladungsträgern und eine reflektierte Welle von besagten Minoritätsträgern einander intensivieren,
**dadurch gekennzeichnet, dass**
das Band in besagter Emitterschicht besagten Multi-Quanten-Barriereabschnitt der Majoritäts-Ladungsträger enthält und einen substantiell vernachlässigbaren BandDiskontinuitätswert aufweist.

**2.** Der bipolare Transistor gemäß Anspruch 1, wobei die Barriere-Schicht (10b) und die Well-Schichten (10a) von besagten Multi-Quanten-Barriereabschnitten aus entsprechenden Halbleitermaterialien bestehen, welche unterschiedliche Bandlücken aufweisen.

**3.** Der bipolare Transistor gemäß Anspruch 1, wobei besagte Basisschicht (4) verzerrt ist.

**4.** Der bipolare Transistor gemäß Anspruch 3, wobei besagte Emitterschicht (5) und besagte Basisschicht (4) aus entsprechenden Halbleitermaterialien bestehen mit unterschiedlichen Bandlücken und
eine Bandlücke zwischen einem Valenzband und einem Leitungsband in besagter Basisschicht (4) einen Abschnitt aufweist, welcher graduell von einer Region von besagter Basisschicht (4) abnimmt, welche in Kontakt ist mit besagter Emitterschicht (5) in Richtung von besagter Basisschicht (4), welche in Kontakt ist mit besagter Kollektorschicht (3).

**5.** Der biopolare Transistor gemäß Anspruch 1, wobei besagte Basisschicht (4) aus einem Halbleiter besteht, welcher zumindest Silizium und Germanium enthält.

**6.** Der bipolare Transistor gemäß Anspruch 5, wobei besagter Multi-Quanten-Barriereabschnitt eine Supergitterstruktur aufweist, welche aus einer multiplen $Si_{1-x}Ge_x/Si$ Schicht besteht.

**7.** Der bipolare Transistor gemäß Anspruch 5, wobei besagter Multi-Quanten-Barriereabschnitt eine Supergitterstruktur aufweist, welche aus einer multiplen $Si_{1-x-y}Ge_xC_y/Si$ Schicht besteht.

**8.** Der bipolare Transistor gemäß Anspruch 1, wobei besagter Multi-Quanten-Barriereabschnitt in einer Region von besagter Emitterschicht (5) angeordnet ist, außerhalb von einer Verarmungsregion, welche ausgebildet ist zwischen besagter Emitterschicht (5) und besagter Basisschicht (4) bei einer Arbeitsspannung, wenn der Transistor in Betrieb ist.

**9.** Der bipolare Transistor gemäß Anspruch 8, wobei besagte Barriereschicht (10b) an dem Ende von besagtem Multi-Quanten-Barriereabschnitt, welcher enger an besagter Basisschicht (4) ist, in solch einer Position angeordnet ist, dass das Tunneln der Ladungsträger von der Verarmungsregion, ausgebildet zwischen der besagten Emitterschicht (5) und besagter Basisschicht (4) zur Well-Schicht (10a), benachbart zu der Barriereschicht (10b) an dem Ende von besagtem Multiquanten-Barriereabschnitt, näher zu besagter Basisschicht (4), zu verhindern.

**10.** Eine Halbleitervorrichtung umfassend einen bipolaren Transistor, umfassend eine Emitterschicht (5, 52, 105), eine Basisschicht (4, 55, 104) und eine Kollektorschicht (3, 56, 103), wobei besagter bipolarer Transistor folgendes aufweist:

einen Multi-Quanten-Barriereabschnitt, welcher in besagter Emitterschicht (3,56,103) zur Verfügung gestellt wird und aus und einer Vielzahl von abwechselnd gestapelten Barriereschichten (12b) und Well-Schichten (12a), , besteht, um die Funktion der reflektierenden einfallenden Welle von Minoritäts-Ladungs-Trägern in der Kollektorschicht (3, 56, 103), injiziert von besagter Basisschicht (4, 55, 104) durchzuführen und wobei dabei solch eine Phase bereitgestellt wird, dass die einfallende Welle und eine reflektierte Welle einander intensivieren,

**dadurch gekennzeichnet, dass**
das Band in besagter Kollektorschicht, welches besagten Multi-Quanten-Barriereabschnitt enthält, aus den Majoritäts-Ladungsträgem, einen substanziell vernachlässigbaren Banddiskontinuitätswert aufweist.

**11.** Die Halbleitervorrichtung gemäß Anspruch 10, wobei die Barriereschichten (12b) und Well-Schichten (12a) von besagtem Multi-Quanten-Barriereabschnitt aus entsprechenden Halbleitermaterialien bestehen, welche unterschiedliche Bandlücken aufweisen.

**12.** Die Halbleitervorrichtung gemäß Anspruch 10, wobei besagte Basisschicht (4, 55, 104) verzerrt ist.

**13.** Die Halbleitervorrichtung gemäß Anspruch 10, wobei besagte Basisschicht (4, 55, 104) aus einem Halbleiter besteht, welcher zumindest Silizium und Germanium enthält.

**14.** Die Halbleitervorrichtung gemäß Anspruch 13, wobei besagter Multi-Quanten-Barriereabschnitt eine Supergitterstruktur aufweist, bestehend aus einer multiplen $Si_{1-x}Ge_x/Si$ Schicht.

**15.** Die Halbleitervorrichtung gemäß Anspruch 13, wobei besagter Multi-Quanten-Barriereabschnitt eine Supergitterstruktur aufweist, bestehend aus einer multiplen $Si_{1-x-y}Ge_xC_y/Si$ Schicht.

**16.** Die Halbleitervorrichtung gemäß Anspruch 10, wobei besagter Multi-Quanten-Barriereabschnitt in einer Region angeordnet ist von besagter Kollektorschicht (3, 56, 103), welche außerhalb einer Verarmungsregion angeordnet ist, welche zwischen besagter Emitterschicht (5, 52, 105) und besagter Basisschicht (4, 55, 104) bei einer Arbeitsspannung liegt, wenn der Transistor in Betrieb ist.

**17.** Die Halbleitervorrichtung gemäß Anspruch 16, wobei die Barriereschicht (12b) am Ende von besagtem Multi-Quanten-Barriereabschnitt, näher an besagter Basisschicht (4, 55, 104), in solch einer Position angeordnet ist, um das Tunneln der Ladungsträger von der Verarmungsregion, ausgebildet zwischen besagter Kollektorschicht (3, 56,103) und besagter Basisschicht (4, 55, 104) zur Well-Schicht (12a), benachbart zu der Barriereschicht, am Ende von besagtem Multi-Quanten-Barriereabschnitt, näher zu besagter Basisschicht (4, 55, 104), zu verhindern.

**18.** Die Halbleitervorrichtung gemäß Anspruch 10, desweiteren umfassend ein Element, welches als Komponenten zwei Regionen aufweist, welche die gleiche Struktur wie eine Basis (104)- / Kollektor (103)- Verknüpfung von besagtem bipolaren Transistor.

**19.** Die Halbleitervorrichtung gemäß Anspruch 18, wobei besagtes Element eine Diode ist.

**20.** Die Halbleitervorrichtung gemäß Anspruch 10, welches desweiteren folgendes umfasst:

einen weiteren bipolaren Transistor, umfassend eine Kollektorschicht, angeordnet in einer Region, welche im allgemeinen durch die Basisschicht von besagtem bipolarem Transistor verwendet wird, eine Basisschicht, angeordnet in einer Region, welche im allgemeinen durch die Kollektorschicht von besagtem bipolaren Transistor verwendet wird und eine Emitterschicht,

wobei besagte Halbleitervorrichtung als ein $I^2L$-Element funktioniert.

**21.** Die Halbleitervorrichtung gemäß Anspruch 20, welche desweiteren umfasst:

zumindest eine Kollektorschicht, verknüpft mit der Basisschicht von besagtem bipolaren Transistor, wobei besagte Halbleitervorrichtung folgendes aufweist:

einen weiteren Multi-Quanten-Barriereabschnitt, welcher in besagter einer weiteren Kollektorschicht zur Verfügung gestellt wird und aus einer Vielzahl von Barriereschichten besteht, welche abweckselnd gestapelt sind, um die Funktion des Reflektierens einer einfallenden Welle von Ladungsträgern durchzuführen, welche von besagter Basisschicht injiziert werden, und
solch eine Phase zur Verfügung stellen, dass die einfallende Welle und eine reflektierende Welle einander intensivieren.

## Revendications

**1.** Transistor bipolaire comprenant une couche émettrice (5), une couche de base (4), et une couche collectrice (3), ledit transistor bipolaire ayant
une partie de barrière multi-quantique étant pourvue dans ladite couche émettrice (5) et composée d'une pluralité de couches barrières (10b) et des couches puits (10a) empilées alternativement pour exécuter la fonction de réflexion d'une onde incidente de porteurs minoritaires dans la couche émettrice (5) injectés depuis ladite couche de base (4) et fournit une phase telle que l'onde incidente desdits porteurs minoritaires et une onde réfléchie desdits porteurs minoritaires s'intensifient l'une l'autre ;
**caractérisé en ce que**
la bande dans ladite couche émettrice contenant ladite partie de barrière multi-quantique, des porteurs majoritaires, a une valeur de discontinuité de bande substantiellement négligeable.

**2.** Transistor bipolaire selon la revendication 1, dans lequel les couches barrières (10b) et des couches puits (10a) de ladite partie de barrière multi-quantique sont composées de matériaux semi-conducteurs respectifs ayant des bandes interdites différentes.

**3.** Transistor bipolaire selon la revendication 1, dans lequel ladite couche de base (4) est contractée.

**4.** Transistor bipolaire selon la revendication 1, dans lequel ladite couche émettrice (5) et ladite couche de base (4) sont composées de matériaux semi-conducteurs respectifs ayant des bandes interdites différentes, et
une bande interdite entre une bande de valence et une bande de conduction dans ladite couche de base (4) a une partie qui décroît graduellement depuis une région de ladite couche de base (4) en contact avec ladite couche émettrice (5) vers une région de ladite couche de base (4) en contact avec ladite couche collectrice (3).

**5.** Transistor bipolaire selon la revendication 1, dans lequel ladite couche de base (4) est composée d'un semi-conducteur contenant au moins du silicium et du germanium.

**6.** Transistor bipolaire selon la revendication 5, dans lequel ladite partie de barrière multi-quantique a une structure de super-réseau composée d'une couche multiple de $Si_{1-x}Ge_x/Si$.

**7.** Transistor bipolaire selon la revendication 5, dans lequel ladite partie de barrière multi-quantique a une structure de super-réseau composée d'une couche multiple de $Si_{1-x-y}Ge_xC_y/Si$.

**8.** Transistor bipolaire selon la revendication 1, dans lequel ladite partie de barrière multi-quantique est disposée dans une région de ladite couche émettrice (5) extérieure à une région d'épuisement formée entre ladite couche émettrice (5) et ladite couche de base (4) à une tension électrique de fonctionnement lorsque ledit transistor est en train de fonctionner.

**9.** Transistor bipolaire selon la revendication 8, dans lequel ladite couche barrière (10b) à l'extrémité de ladite partie de barrière multi-quantique plus proche de ladite couche de base (4) est disposée dans une telle position de sorte à empêcher la tunnellisation des porteurs depuis la région d'épuisement formée entre ladite couche émettrice (5) et ladite couche de base (4) à la couche puit (10a) adjacente à la couche barrière (10b) à l'extrémité de ladite partie de barrière multi-quantique plus proche de ladite couche de base (4).

10. Dispositif semi-conducteur comprenant un transistor bipolaire comprenant une couche émettrice (5, 52,105), une couche de base (4, 55, 104), et une couche collectrice (3, 56, 103), ledit transistor bipolaire ayant,
une partie de barrière multi-quantique étant pourvue dans ladite couche collectrice (3, 56, 103) et composée d'une pluralité de couches barrières (12b) et de couches puits (12a) empilées alternativement pour exécuter la fonction de réflexion d'une onde incidente de porteurs minoritaires dans la couche collectrice (3, 56, 103) injectés depuis ladite couche de base (4, 55, 104) et fournit une phase telle que l'onde incidente et une onde réfléchie s'intensifient l'une l'autre.
**caractérisé en ce que**
la bande dans ladite couche collectrice contenant ladite partie de barrière multi-quantique, des porteurs majoritaires, a une valeur de discontinuité de bande substantiellement négligeable.

11. Dispositif semi-conducteur selon la revendication 10, dans lequel les couches barrières (12b) et des couches puits (12a) de ladite partie de barrière multi-quantique sont composées de matériaux semi-conducteurs respectifs ayant des bandes interdites différentes.

12. Dispositif semi-conducteur selon la revendication 10, dans lequel ladite couche de base (4, 55, 104) est contractée.

13. Dispositif semi-conducteur selon la revendication 10, dans lequel ladite couche de base (4, 55, 104) est composée d'un semi-conducteur contenant au moins du silicium et du germanium.

14. Dispositif semi-conducteur selon la revendication 13, dans lequel ladite partie de barrière multi-quantique a une structure de super-réseau composée d'une couche multiple de $Si_{1-x}Ge_x/Si$.

15. Dispositif semi-conducteur selon la revendication 13, dans lequel ladite partie de barrière multi-quantique a une structure de super-réseau composée d'une couche multiple de $Si_{1-x-y}Ge_xC_y/Si$.

16. Dispositif semi-conducteur selon la revendication 10, dans lequel ladite partie de barrière multi-quantique est disposée dans une région de ladite couche collectrice (3, 56, 103) extérieure à une région d'épuisement formée entre ladite couche émettrice (5, 52, 105) et ladite couche de base (4, 55, 104) à une tension électrique de fonctionnement lorsque ledit transistor est en train de fonctionner.

17. Dispositif semi-conducteur selon la revendication16, dans lequel ladite couche barrière (12b) à l'extrémité de ladite partie de barrière multi-quantique plus proche de ladite couche de base (4, 55, 104) est disposée dans une telle position de sorte à empêcher la tunnellisation des porteurs depuis la région d'épuisement formée entre ladite couche collectrice (3, 56, 103) et ladite couche de base (4, 55, 104) à la couche puit (12a) adjacente à la couche barrière à l'extrémité de ladite partie de barrière multi-quantique plus proche de ladite couche de base (4,55, 104).

18. Dispositif semi-conducteur selon la revendication 10, comprenant en plus un élément ayant, comme composantes, deux régions ayant la même structure qu'une jonction de base (104) / collectrice (103) dudit transistor bipolaire.

19. Dispositif semi-conducteur selon la revendication 18, dans lequel ledit élément est une diode.

20. Dispositif semi-conducteur selon la revendication 10, comprenant en plus :

   un autre transistor bipolaire comprenant une couche collectrice disposée dans une région utilisée en commun par la couche de base dudit transistor bipolaire, une couche de base disposée dans une région utilisée en commun par la couche collectrice dudit transistor bipolaire, et une couche émettrice,

   ledit dispositif semi-conducteur fonctionnant comme un élément $I^2L$.

21. Dispositif semi-conducteur selon la revendication 20, comprenant en plus :

   au moins une autre couche collectrice connectée à la couche de base dudit transistor bipolaire, ledit dispositif semi-conducteur ayant,
une autre partie de barrière multi-quantique étant pourvue dans ladite une autre couche collectrice et composée d'une pluralité de couches barrières et de couches puits empilées alternativement pour exécuter la fonction de réflexion d'une onde incidente de porteurs injectés depuis ladite couche de base et fournit une phase telle que l'onde incidente et une onde réfléchie s'intensifient l'une l'autre.

# Fig. 1

Si LAYER

SiGe LAYER

Si LAYER

L1

L2

BASE ELECTRODE
21

EMITTER
ELECTRODE
22

Si EMITTER
CONTACT LAYER

Si COLLECTOR
LAYER 3

6

5 Si EMITTER LAYER

10 MQB LAYER

4 SiGe BASE LAYER

2

20 COLLECTOR
ELECTRODE

Si SUBCOLLECTOR
LAYER

1
Si SUBSTRATE

# Fig. 2

5
↓
Emitter

4
↓
Base

3
↓
Collector

10 MQB LAYER

WELL LAYER   BARRIER LAYER

10a   10b

225meV

150meV

L1

L2

DEPLETION
REGION

# Fig. 3

Si/SiGe(x=0.2)   ΔEv=150meV

Si/SiGe(x=0.3)   ΔEv=225meV

Si/SiGe(x=0.4)   ΔEv=300meV

# Fig. 4

---◇--- Si/SiGe(x=0.2)MQB
        Tc=180nm

--□-- Si/SiGe(x=0.3)MQB
      Tc=56nm

——○—— Si/SiGe(x=0.4)MQB
        Tc=25nm

Well/Barrier Thickness in Atomic Monolayers
(1 Atomic Monolayer:5.43/4 Å)

# Fig. 5

# Fig. 6

## Fig. 7 (a)

AT LOW
TEMPERATURE T

AT HIGH
TEMPERATURE T

## Fig. 7 (b)

line3

$\beta$

line1    line2

T

Fig. 8

EMITTER
ELECTRODE
22

Si EMITTER
CONTACT LAYER
6

BASE ELECTRODE
21

5 Si EMITTER LAYER

11 δ DOPED Si LAYER

Si COLLECTOR LAYER
3

4 SiGe BASE LAYER

20 COLLECTOR
ELECTRODE

Si 2
SUBCOLLECTOR
LAYER

1 Si SUBSTRATE

# Fig. 9

# Fig. 10

# Fig. 11

CARRIER CONCENTRATION IN δ
DOPED Si LAYER (cm$^{-3}$)

Fig. 12

# Fig. 13

Si LAYER

L1

SiGe LAYER

L2

Si LAYER

EMITTER
ELECTRODE
22

Si EMITTER
CONTACT LAYER
6

BASE ELECTRODE
21

5 Si EMITTER LAYER

4 SiGe BASE LAYER

12 MQB LAYER

Si COLLECTOR
LAYER 3

20 COLLECTOR
ELECTRODE

Si 2
SUBCOLLECTOR
LAYER

1 Si SUBSTRATE

# Fig. 14

5         4         3

Emitter     Base     Collector

12 MQB LAYER

WELL LAYER    BARRIER LAYER

12a      12b

150meV

130meV

L1 →

→ ←L2

# Fig. 15

# Fig. 16

# Fig.17

BIPOLAR TRANSISTOR
FORMATION REGION

DIODE FORMATION
REGION

Rexp2

116    109    115    Rexp1    117    111    118    108    109    106    Rexp1    119    Rexp2

108    106    111    112    102    101

104    110    105    103    104    110    105    103

## Fig. 18
### PRIOR ART

Si

SiGe

Emitter

Base

Si

Collector

## Fig. 19
### PRIOR ART

SiGe

Si

Emitter

Base

Si

Collector